(19) Europäisches Patentamt
European Patent Office
Office européen des brevets

(11) **EP 2 278 607 B1**

(12) **EUROPÄISCHE PATENTSCHRIFT**

(45) Veröffentlichungstag und Bekanntmachung des Hinweises auf die Patenterteilung:
**18.06.2014   Patentblatt 2014/25**

(51) Int Cl.:
*H01J 37/09* *(2006.01)*        *H01J 37/28* *(2006.01)*
*H01J 37/15* *(2006.01)*

(21) Anmeldenummer: **10170421.1**

(22) Anmeldetag: **22.07.2010**

(54) **Teilchenstrahlgerät mit einer Blendeneinheit und Verfahren zur Einstellung eines Strahlstroms in einem Teilchenstrahlgerät**

Charged particle beam device with an aperture unit and method for regulating a beam current in a charged particle beam device

Appareil à faisceau de particules chargées avec unité d'ouverture et procédé de réglage d'un courant de faisceau dans un appareil à faisceau de particules chargées

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **24.07.2009   DE 102009028013**

(43) Veröffentlichungstag der Anmeldung:
**26.01.2011   Patentblatt 2011/04**

(73) Patentinhaber: **Carl Zeiss Microscopy GmbH**
**07745 Jena (DE)**

(72) Erfinder:
• **Preikszas, Dirk**
**73447 Oberkochen (DE)**

• **Albiez, Michael**
**73431 Aalen (DE)**

(74) Vertreter: **Tongbhoyai, Martin**
**Patentanwälte Freischem**
**Salierring 47-53**
**50677 Köln (DE)**

(56) Entgegenhaltungen:
JP-A- 11 086 767        JP-A- 59 221 953
JP-U- 61 076 673        US-A- 3 526 766
US-A- 3 588 586        US-A1- 2007 057 185
US-A1- 2007 200 069    US-A1- 2007 257 207

EP 2 278 607 B1

## Beschreibung

Die Erfindung betrifft ein Teilchenstrahlgerät mit einer Blendeneinheit. Dabei wird vorstehend und auch nachstehend unter einem Teilchenstrahlgerät sowohl ein Elektronenstrahlgerät, insbesondere ein Rasterelektronenmikroskop (nachfolgend auch SEM genannt) und ein Transmissionselektronenmikroskop (nachfolgend auch TEM genannt), als auch ein Ionenstrahlgerät verstanden. Die Erfindung ist daher nicht auf Elektronenstrahlgeräte eingeschränkt. Sie ist bei jedem Teilchenstrahlgerät einsetzbar.

Elektronenstrahlgeräte, insbesondere SEM, werden zur Untersuchung von Oberflächen von Objekten (Proben) verwendet. Hierzu wird bei einem SEM ein Elektronenstrahl (nachfolgend auch Primärelektronenstrahl genannt) mittels eines Strahlerzeugers erzeugt und durch eine Objektivlinse auf das zu untersuchende Objekt fokussiert. Mittels einer Ablenkeinrichtung wird der Primärelektronenstrahl rasterförmig über die Oberfläche des zu untersuchenden Objektes geführt. Die Elektronen des Primärelektronenstrahls treten dabei in Wechselwirkung mit dem Objekt. Als Folge der Wechselwirkung entsteht bzw. entstehen Wechselwirkungsteilchen und/oder Wechselwirkungsstrahlung, welche detektiert werden. Die auf diese Weise erhaltenen Detektionssignale werden ausgewertet.

Als Wechselwirkungsteilchen werden insbesondere Elektronen aus der Objektoberfläche emittiert (sogenannte Sekundärelektronen) oder Elektronen des Primärelektronenstrahls zurückgestreut (sogenannte Rückstreuelektronen). Die Sekundärelektronen und die Rückstreuelektronen werden mit mindestens einem Detektor des Elektronenstrahlgeräts detektiert. Das hierdurch erzeugte Detektorsignal wird zur Bilderzeugung verwendet.

In der Regel ist man an einer hochauflösenden Bilderzeugung interessiert. Das Elektronenstrahlgerät wird hierzu im sogenannten Hochauflösungsmodus betrieben. Bei dem Elektronenstrahlgerät erzeugt der Strahlerzeuger einen Primärelektronenstrahl mit einem vorgebbaren Strahlstrom im Bereich von ungefähr 1 $\mu$A bis 100 pA, beispielsweise 20 pA. Der Primärelektronenstrahl wird im Wesentlichen entlang einer optischen Achse des Elektronenstrahlgeräts in Richtung einer zu untersuchenden Probe geführt. Im Elektronenstrahlgerät ist eine erste Blende angeordnet, welche den Strahlstrom des Primärelektronenstrahls auf ungefähr 1 nA bis 100 nA, beispielsweise 20 nA, reduziert. Eine zweite Blende, welche der ersten Blende in Richtung der Probe nachgeschaltet ist, verringert wiederum den Strahlstrom, und zwar auf Werte im Bereich von einigen pA bis ungefähr 500 pA, beispielsweise im Bereich von 1 pA bis 200 pA. Durch das beschriebene Reduzieren des Strahlstroms wird erzielt, dass die Wechselwirkungen der im Primärelektronstrahl verbleibenden Elektronen untereinander vernachlässigbar klein werden und dass eine hierdurch bedingte Aufweitung des Primärelektronenstrahls vermieden wird. Dies ist für die hochauflösende Bilderzeugung wesentlich.

Neben der oben genannten hochauflösenden Bilderzeugung gibt es weitere bei einem Elektronenstrahlgerät einsetzbare Untersuchungsverfahren, mit denen ein zu untersuchendes Objekt untersucht werden kann. Hierzu zählt insbesondere das so genannte EBSD-Verfahren ("Electron Backscattered Diffraction"), bei dem Beugungsmuster von Elektronen bestimmt werden, welche nach Einfall des Primärelektronenstrahls auf ein zu untersuchendes Objekt an dem Objekt gestreut werden. Ein weiteres Untersuchungsverfahren basiert auf der Detektion von Kathodolumineszenzlicht, das bei Einfall des Primärelektronenstrahls auf das zu untersuchende Objekt aus dem Objekt austritt. Weitere Untersuchungsverfahren sind beispielsweise die Untersuchung mittels energiedispersiver Röntgenspektroskopie (EDX) und die Untersuchung mittels wellenlängen-dispersiver Röntgenspektroskopie (WDX). Bei den vorgenannten Untersuchungsverfahren ist es jedoch wünschenswert, das Elektronenstrahlgerät im Hochstrommodus zu betreiben. Hierunter wird verstanden, dass der Primärelektronenstrahl mit einem Strahlstrom im Bereich von einigen nA, beispielsweise 100 nA bis 500 nA, auf das zu untersuchende Objekt trifft. Hierdurch werden bei den vorgenannten Untersuchungsverfahren bessere Zählraten erzielt, was vorteilhaft für die Auswertung mittels dieser Untersuchungsverfahren ist.

Demnach besteht ein Bedürfnis, den Strahlstrom eines Teilchenstrahls, insbesondere eines Elektronenstrahls, variieren zu können, um jeweils einen geeigneten Strahlstrom für die gewünschte Betriebsart des Teilchenstrahlgeräts (Hochauflösungsmodus oder Hochstrommodus) einstellen zu können. Dabei sollte beim Hochauflösungsmodus eine gute Auflösung bei der Bilderzeugung erzielt werden können, beispielsweise im Bereich von 0,5 nm bis 3,0 nm, je nach Energie des Primärelektronenstrahls.

Aus dem Stand der Technik ist es auch bekannt, ein Elektronenstrahlgerät mit einer oder mit mehreren Druckstufen zu versehen, welche Bereiche des Elektronenstrahlgeräts trennen, die ein Vakuum mit jeweils einem unterschiedlichen Druck aufweisen. So trennt beispielsweise eine Druckstufe einen ersten Bereich, in dem ein Strahlerzeuger angeordnet ist und der in der Regel ein Ultrahochvakuum aufweist ($10^{-6}$ bis $10^{-10}$ Pa), von einem zweiten Bereich, der ein Hochvakuum ($10^{-1}$ bis $10^{-5}$ Pa) aufweist. Der zweite Bereich kann beispielsweise eine Probenkammer des Elektronenstrahlgeräts, in der eine Probe angeordnet ist, oder ein Zwischendruckbereich sein, der zur Probenkammer hinführt. Bei einigen Elektronenstrahlgeräten ist es vorgesehen, die Druckstufen gleichzeitig als Blenden auszubilden. Durch die Druckstufen wird verhindert, dass sich das Ultrahochvakuum des ersten Bereichs durch Verschmutzungen aus dem zweiten Bereich, beispielsweise aufgrund von Einführung von Gasen im Bereich der Probe, verschlechtert.

Aus dem Stand der Technik ist ein Elektronenstrahlgerät bekannt, das eine Einstellung des Strahlstroms für eine gewünschte Betriebsart ermöglicht. Dieses bekannte Elektronenstrahlgerät weist einen Elektronenstrahlerzeuger und eine Objektivlinse zur Fokussierung eines Primärelektronenstrahls auf ein zu untersuchendes Objekt auf. Ferner weist das bekannte Elektronenstrahlgerät eine erste Kondensorlinse und eine zweite Kondensorlinse auf, wobei ausgehend von dem Elektronenstrahlerzeuger in Richtung der Objektivlinse gesehen zunächst die erste Kondensorlinse und dann die zweite Kondensorlinse angeordnet sind. Ferner ist eine erste Blendeneinheit vorgesehen, die zwischen dem Elektronenstrahlerzeuger und der ersten Kondensorlinse angeordnet ist. Ferner ist eine zweite Blendeneinheit vorgesehen, die zwischen der ersten Kondensorlinse und der zweiten Kondensorlinse angeordnet ist. Die zweite Blendeneinheit ist als Druckstufenblende ausgebildet. Die erste Blendeneinheit weist mehrere unterschiedliche Blendenöffnungen auf. Durch Verschieben der ersten Blendeneinheit in einer zur optischen Achse senkrechten Ebene und Führen einer gewünschten Blendenöffnung unter den Primärelektronenstrahl wird der Strahlstrom eingestellt. Das bekannte Elektronenstrahlgerät soll es auch ermöglichen, dass Kontaminationen der als Druckstufenblende ausgebildeten zweiten Blendeneinheit verhindert werden. Diese Kontaminationen entstehen durch den auf die Druckstufenblende einfallenden Primärelektronenstrahl.

Der Stand der Technik weist jedoch den Nachteil auf, dass bei gewissen Erregungen der ersten Kondensorlinse der Primärelektronenstrahl nicht durch die zweite Blendeneinheit tritt. Der Strahlverlauf des Primärelektronenstrahls ist nicht modusunabhängig (wobei ein Modus die gewählte Primärenergie und den gewählten Strahlstrom beschreibt). Man spricht in diesem Fall auch von einem "Weglaufen" des Primärelektronenstrahls. Demnach ist es wünschenswert, einen möglichst modusunabhängigen Strahlverlauf des Primärelektronenstrahls zu erzielen.

Ferner ist aus dem Stand der Technik ein Teilchenstrahlgerät bekannt, das eine Blendeneinheit mit einem ersten Blendenelement und einem zweiten Blendenelement aufweist. Sowohl das erste Blendenelement als auch das zweite Blendenelement weisen einen V-förmigen Abschnitt auf, die zur Bildung einer Blendenöffnung zusammenwirken. Das erste Blendenelement und das zweite Blendenelement überlappen einander und können in zueinander gegensätzliche Richtungen bewegt werden. Auf diese Weise werden die Größe der Blendenöffnung und somit auch der Strahlstrom eines Teilchenstrahls des Teilchenstrahlgeräts eingestellt.

Hinsichtlich des oben genannten Standes der Technik wird auf die US 7,550,724 B2 sowie die US 2007/0138403 A1 verwiesen.

Die beiden aus dem Stand der Technik bekannten verstellbaren Blendeneinheiten weisen einen Nachteil auf. Sie werden mit einem Manipulator mechanisch durch Umlenkhebel manuell oder mit einem Stellmotor zur Einstellung der Blendenöffnung bewegt. Aufgrund unvermeidbarer Ungenauigkeiten der mechanischen Bauteile des Manipulators sind die Positionen, die für die einzelnen Blendeneinheiten eingestellt werden müssen, um eine bestimmte Blendenöffnung in den Strahlengang des Teilchenstrahls zu bringen, in der Regel nicht reproduzierbar. Um daher einen gewünschten Strahlstrom zu erhalten, muss die Blendeneinheit nachjustiert werden. Dies erfolgt in der Regel durch Bewegen der Blendeneinheit mittels des Manipulators und Beobachten des Strahlstroms.

Auch wenn der Manipulator mit Piezoelementen betrieben wird, ist die Position der Blendeneinheit, um einen bestimmten Strahlstrom zu erreichen, nicht ausreichend gut einstellbar. Auch eine Einstellung mittels eines Piezoelements unterliegt Fehlern, welche beispielsweise durch eine Hysterese entstehen können. Aus diesem Grund muss bei einer Benutzung eines Piezoelements zur Betätigung eines Manipulators ein aufwendiges Messsystem zur Bestimmung der zurückgelegten Wege des Manipulators benutzt werden, um die gewünschte Blendenöffnung der Blendeneinheit genau unter den Teilchenstrahl positionieren zu können.

Hinsichtlich weiteren Standes der Technik wird auf die JP 61076673 U, die US 3,526,766 A, die JP 59221953 A, die JP 11086767 A, die US 2007/0257207 sowie die US 3,588,586 A verwiesen.

Der Erfindung liegt daher die Aufgabe zu Grunde, ein Teilchenstrahlgerät mit einer Blendeneinheit anzugeben, mit denen eine genaue Einstellung eines Strahlstroms eines Teilchenstrahls ausreichend gut und mit einem geringen Aufwand erfolgen kann sowie ein möglichst modusunabhängiger Strahlverlauf des Teilchenstrahls erzielt wird.

Erfindungsgemäß wird diese Aufgabe durch ein Teilchenstrahlgerät mit den Merkmalen des Anspruchs 1 gelöst. Weitere Merkmale für Ausführungsbeispiele der Erfindung ergeben sich aus der nachfolgenden Beschreibung, den beigefügten Ansprüchen und/oder den beigefügten Figuren.

Das erfindungsgemäße Teilchenstrahlgerät weist einen Teilchenstrahlerzeuger auf, der Teilchen erzeugt. Die Teilchen bilden einen Teilchenstrahl. Ferner ist eine Objektivlinse zur Fokussierung des Teilchenstrahls auf eine Probe vorgesehen. Das Teilchenstrahlgerät weist darüber hinaus eine erste Kondensorlinse und eine zweite Kondensorlinse auf. Ausgehend von dem Teilchenstrahlerzeuger in Richtung der Objektivlinse gesehen sind zunächst die erste Kondensorlinse und dann die zweite Kondensorlinse in dem Teilchenstrahlgerät angeordnet. Mit anderen Worten ausgedrückt sind die vorgenannten Bauteile in der folgenden Reihenfolge entlang einer optischen Achse des Teilchenstrahlgeräts angeordnet: Teilchenstrahlerzeuger - erste Kondensorlinse - zweite Kondensorlinse - Objektivlinse. Darüber hinaus weist das erfindungsgemäße Teilchenstrahlgerät mindestens eine erste Blendeneinheit auf, die zwischen dem Teilchenstrahlerzeuger und der ersten Kondensorlinse angeordnet ist. Zusätzlich zu der ersten Blendeneinheit ist mindestens eine zweite Blendeneinheit vorgesehen, die zwischen der ersten Kondensorlinse und der zweiten Kondensorlinse angeordnet ist.

Die erste Kondensorlinse weist einen ersten Polschuh und einen zweiten Polschuh auf, wobei ausgehend von dem Teilchenstrahlerzeuger in Richtung der Objektivlinse gesehen zunächst der erste Polschuh und dann der zweite Polschuh angeordnet sind. Mit anderen Worten ausgedrückt sind die vorgenannten Bauteile in der folgenden Reihenfolge entlang der optischen Achse des Teilchenstrahlgeräts angeordnet: Teilchenstrahlerzeuger - erste Blendeneinheit - erster Polschuh - zweiter Polschuh - zweite Blendeneinheit - zweite Kondensorlinse - Objektivlinse. Der erste Polschuh wird häufig auch als oberer Polschuh bezeichnet, während der zweite Polschuh häufig auch als unterer Polschuh bezeichnet wird. Sowohl der erste Polschuh als auch der zweite Polschuh sind unabhängig voneinander relativ zur zweiten Blendeneinheit justierbar. Dies bedeutet, dass die relative Position des ersten Polschuhs zur zweiten Blendeneinheit einstellbar ist. Entsprechendes gilt für den zweiten Polschuh. Ferner ist vorgesehen, dass die zweite Blendeneinheit eine Druckstufenblende ist, die einen ersten Bereich, in welchem ein Vakuum mit einem ersten Druck herrscht, und einen zweiten Bereich, in welchem ein Vakuum mit einem zweiten Druck herrscht, voneinander trennt. Dabei sind der erste Druck und der zweite Druck in der Regel unterschiedlich zueinander.

Die zweite Blendeneinheit ist beispielsweise als Lochblende ausgestaltet und weist eine Öffnung für den Durchtritt des Teilchenstrahls auf, welche eine Ausdehnung im Bereich von 10 $\mu$m bis 100 $\mu$m aufweist, vorzugsweise 25 $\mu$m bis 50 $\mu$m, beispielsweise 35 $\mu$m.

Das vorgenannte Teilchenstrahlgerät weist zwei vorteilhafte Eigenschaften auf. Zum einen ist der Strahlstrom des Teilchenstrahls über einen großen Bereich kontinuierlich variierbar, beispielsweise in einem Bereich von 10 pA bis 300 nA. Dies wird dadurch erzielt, dass die Erregung der ersten Kondensorlinse variiert wird. Zum anderen ist die zweite Blendeneinheit als Druckstufe ausgebildet, die beispielsweise einen ersten Bereich, in dem der Teilchenstrahlerzeuger angeordnet ist und der in der Regel ein Ultrahochvakuum aufweist ($10^{-6}$ Pa bis $10^{-10}$ Pa), von einem zweiten Bereich, der ein Hochvakuum aufweist ($10^{-1}$ Pa bis $10^{-5}$ Pa), trennt. Der zweite Bereich kann beispielsweise eine Probenkammer des Teilchenstrahlgeräts, in der eine Probe angeordnet ist, oder ein Zwischendruckbereich sein, der zur Probenkammer hinführt. Durch die zweite Blendeneinheit wird verhindert, dass sich das Ultrahochvakuum des ersten Bereichs durch Verschmutzungen aus dem zweiten Bereich, beispielsweise aufgrund von Einführung von Gasen im Bereich der Probe, verschlechtert. Der druckdichte Einbau der als Druckstufe ausgebildeten zweiten Blendeneinheit erschwert deren mechanische Justierung. Damit der Verlauf des Primärelektronenstrahls stets modusunabhängig bleibt, ist es darum vorgesehen, sowohl den ersten Polschuh als auch den zweiten Polschuh der ersten Kondensorlinse relativ zur zweiten Blendeneinheit zu justieren. Die Justierung erfolgt dabei für den ersten Polschuh und den zweiten Polschuh unabhängig voneinander. Überlegungen haben ergeben, dass eine Justierung der ersten Kondensorlinse als Ganzes (also eine Justierung des ersten Polschuhs und des zweiten Polschuhs stets miteinander) nicht ausreicht, um einen modusunabhängigen Strahlverlauf zu erhalten. Vielmehr kommt es wirklich darauf an, dass der erste Polschuh und der zweite Polschuh unabhängig voneinander justiert werden.

Bei Verwendung einer Dünnschichtblende als zweite Blendeneinheit kann man die zweite Blendeneinheit mit einem entsprechend fokussierten Teilchenstrahl so stark erhitzen, dass eventuell aufgebrachte Kontaminationen wieder beseitigt werden. Dabei wird vorstehend und auch nachstehend unter einer Dünnschichtblende eine Blende verstanden, deren Materialdicke im Bereich des Blendenrandes und in einem Bereich mit mindestens dem doppelten Durchmesser der Blendenöffnung (beispielsweise ca. 100 $\mu$m) unter 10 $\mu$m liegt.

Die Einstellung des Strahlstroms erfolgt beispielsweise in Abhängigkeit der Untersuchungsmethode, die angewendet werden soll. Falls ein Bild der Oberfläche eines zu untersuchenden Objekts erzeugt werden soll, wird beispielsweise der Hochauflösungsmodus des Teilchenstrahlgeräts eingestellt. Hierzu wird dann ein Strahlstrom im Bereich von beispielsweise 10 pA bis 500 pA gewählt. Will man aber im Hochstrommodus arbeiten, um beispielsweise die weiter oben genannten weiteren Untersuchungsverfahren anzuwenden, wählt man einen Strahlstrom beispielsweise im Bereich von 10 nA bis einigen 100 nA.

Die zweite Kondensorlinse weist ebenfalls eine besondere Funktion für die Erfindung auf. So ist es mittels der zweiten Kondensorlinse möglich, den Durchmesser des Teilchenbündels in der Objektivlinse derart einzustellen, dass für einen gewählten Strahlstrom eine gute laterale Auflösung erzielt wird.

Um einen besonders guten und modusunabhängigen Strahlverlauf des Teilchenstrahls zu erhalten, ist es bei einer weiteren Ausführungsform der Erfindung vorgesehen, dass die zweite Kondensorlinse einen dritten Polschuh und einen vierten Polschuh aufweist, wobei ausgehend von dem Teilchenstrahlerzeuger in Richtung der Objektivlinse gesehen zunächst der dritte Polschuh und dann der vierte Polschuh angeordnet sind. Mit anderen Worten ausgedrückt sind die vorgenannten Bauteile des Teilchenstrahlgeräts in der folgenden Reihenfolge entlang der optischen Achse des Teilchenstrahlgeräts angeordnet: Teilchenstrahlerzeuger - erste Blendeneinheit - erster Polschuh - zweiter Polschuh - zweite Blendeneinheit - dritter Polschuh - vierter Polschuh- Objektivlinse. Der dritte Polschuh und der vierte Polschuh sind gemeinsam oder unabhängig voneinander relativ zur zweiten Blendeneinheit justierbar.

Bei einer weiteren Ausführungsform der Erfindung ist es vorgesehen, zwischen der ersten Kondensorlinse und der zweiten Kondensorlinse mindestens eine Ablenkeinrichtung anzuordnen. Beispielsweise ist die Ablenkeinrichtung als Ablenksystem ausgebildet, welches eine erste Ablenkeinheit und eine zweite Ablenkeinheit aufweist. Ein derartiges Ablenksystem wird auch als Doppelablenksystem bezeichnet. Beispielsweise ist es vorgesehen, dass die zweite Blendeneinheit zwischen der ersten Ablenkeinheit und der zweiten Ablenkeinheit angeordnet ist. Mittels der Ablenkeinrichtung, beispielsweise mittels des beschriebenen Ablenksystems, wird der Teilchenstrahl nach Durchtritt durch die zweite Blendeneinheit relativ zur zweiten Kondensorlinse ausgelenkt und justiert. Auch hierdurch wird ein guter und modusunabhängiger Strahlverlauf des Teilchenstrahls erzielt.

Bei einer wiederum weiteren Ausführungsform der Erfindung weist die erste Blendeneinheit eine Blendenöffnung mit einer veränderbaren Öffnungsgröße auf. Diese Ausführungsform ist insbesondere beim Hochauflösungsmodus vorgesehen. Beispielsweise weist die Blendeneinheit eine Blendenöffnung mit einer ersten Öffnungsgröße und mit einer zweiten Öffnungsgröße auf, wobei die erste Öffnungsgröße größer als die zweite Öffnungsgröße ist. Durch Wechsel der Blendenöffnung von der ersten Öffnungsgröße auf die zweite Öffnungsgröße wird erzielt, dass Teilchen frühzeitig aus dem Teilchenstrahl ausgeblendet werden (nämlich an der ersten Blendeneinheit). Diese Teilchen würden ansonsten an der zweiten Blendeneinheit ohnehin ausgeblendet. Auf diese Weise werden Wechselwirkungen von Teilchen des Teilchenstrahls untereinander, welche zwischen der ersten Blendeneinheit und der zweiten Blendeneinheit entstehen können, reduziert oder vermieden. Auf diese Weise wird einer Verbreiterung des Teilchenstrahls entgegengewirkt, so dass die Auflösung bei der Bilderzeugung verbessert wird. Der maximale Strahlstrom des Teilchenstrahls wird bei dieser Ausführungsform durch die maximale Blendenöffnung der ersten Blendeneinheit bestimmt.

Bei einer weiteren Ausführungsform der Erfindung weist die erste Blendeneinheit ein erstes Blendenelement und ein zweites Blendenelement auf, wobei das erste Blendenelement und das zweite Blendenelement zur Bildung der Blendenöffnung zusammenwirken. Mit anderen Worten ausgedrückt, sind das erste Blendenelement und das zweite Blendenelement derart relativ zueinander angeordnet, dass die Blendenöffnung gebildet wird. Das erste Blendenelement und das zweite Blendenelement sind zur Bildung der Blendenöffnung relativ zueinander bewegbar. So ist es beispielsweise vorgesehen, entweder das erste Blendenelement oder das zweite Blendenelement beweglich auszubilden. Alternativ hierzu ist es beispielsweise vorgesehen, sowohl das erste Blendenelement als auch das zweite Blendenelement beweglich auszubilden.

Bei einer weiteren Ausführungsform der Erfindung ist es ferner vorgesehen, dass die erste Blendeneinheit ein erstes Blendenanschlagelement und ein zweites Blendenanschlagelement aufweist. Das erste Blendenelement ist derart beweglich, dass es an dem ersten Blendenanschlagelement zur Bildung der Blendenöffnung anliegt. Zusätzlich oder alternativ hierzu ist es vorgesehen, dass das zweite Blendenelement derart beweglich ist, dass es an dem zweiten Blendenanschlagelement zur Bildung der Blendenöffnung anliegt. Bei einer wiederum weiteren Ausführungsform der Erfindung ist vorgesehen, dass die erste Blendeneinheit ein erstes Anschlagelement und ein zweites Anschlagelement aufweist, wobei das erste Blendenelement derart beweglich ausgebildet ist, dass es an dem ersten Anschlagelement zur Bildung der Blendenöffnung mit einer ersten Öffnungsgröße oder an dem zweiten Anschlagelement zur Bildung der Blendenöffnung mit einer zweiten Öffnungsgröße anliegt. Die erste Öffnungsgröße und die zweite Öffnungsgröße sind unterschiedlich ausgebildet. Beispielsweise ist die zweite Öffnungsgröße größer als die erste Öffnungsgröße. Aufgrund des ersten Anschlagelements und des zweiten Anschlagelements werden zwei Positionen vorgegeben, welche das erste Blendenelement einnehmen kann. In einer ersten Position, in der das erste Blendenelement an dem ersten Anschlagelement anliegt, wirkt das erste Blendenelement mit dem zweiten Blendenelement derart zusammen, dass die Blendenöffnung mit der ersten Öffnungsgröße bereitgestellt wird. In einer zweiten Position, in der das erste Blendenelement an dem zweiten Anschlagelement anliegt, wirkt das erste Blendenelement mit dem zweiten Blendenelement derart zusammen, dass die Blendenöffnung mit der zweiten Öffnungsgröße bereitgestellt wird. Das erste Anschlagelement und das zweite Anschlagelement sind beispielsweise vor Einbau der ersten Blendeneinheit in das Teilchenstrahlgerät auf einer Grundplatte montierbar und werden vor Inbetriebnahme des Teilchenstrahlgeräts justiert. Aufgrund dessen ist es möglich, ganz bestimmte Öffnungsgrößen der Blendenöffnung zu erzielen, durch die der Teilchenstrahl treten kann. Die erste Öffnungsgröße und die zweite Öffnungsgröße können beispielsweise im Bereich von ungefähr 10 $\mu$m bis 500 $\mu$m liegen, wobei beispielsweise die zweite Öffnungsgröße größer als die erste Öffnungsgröße gewählt ist (oder umgekehrt).

Bei einer weiteren Ausführungsform der Erfindung ist das zweite Blendenelement beweglich ausgebildet. Darüber hinaus weist die erste Blendeneinheit ein drittes Anschlagelement und ein viertes Anschlagelement auf. Das zweite Blendenelement ist derart beweglich ausgebildet, dass es an dem dritten Anschlagelement oder dem vierten Anschlagelement zur Bildung der Blendenöffnung anliegt. Dieses Ausführungsbeispiel ermöglicht es, dass die Blendenöffnung sowohl durch Bewegen und Anlegen des ersten Blendenelements an dem ersten Anschlagelement bzw. dem zweiten Anschlagelement als auch durch Bewegen und Anlegen des zweiten Blendenelements an dem dritten Anschlagelement bzw. vierten Anschlagelement einstellbar ist. Alternativ hierzu ist es auch möglich, entweder nur das erste Blendenelement oder nur das zweite Blendenelement zu bewegen und anzulegen, um die Blendenöffnung einzustellen. Eine Bewegung sowohl des ersten Blendenelements als auch des zweiten Blendenelements ermöglicht es besonders einfach, die erste Öffnungsgröße der Blendenöffnung recht klein zu wählen (beispielsweise im Bereich von 10 $\mu$m bis 100 $\mu$m) und die zweite Öffnungsgröße der Blendenöffnung recht groß zu wählen (beispielsweise im Bereich von 50 $\mu$m bis 500 $\mu$m).

Bei einer weiteren Ausführungsform der Erfindung ist das zuvorgenannte erste Blendenanschlagelement als das zweite Anschlagelement ausgebildet, während das zuvorgenannte zweite Blendenanschlagelement als das dritte Anschlagelement ausgebildet ist.

Bei einem wiederum weiteren Ausführungsbeispiel der Erfindung weist die erste Blendeneinheit mindestens eine Antriebseinheit zur Bewegung des ersten Blendenelements und/oder des zweiten Blendenelements auf. Beispielsweise ist es vorgesehen, dass die erste Blendeneinheit eine erste Antriebseinheit zum Bewegen des ersten Blendenelements und eine zweite Antriebseinheit zum Bewegen des zweiten Blendenelements aufweist. Alternativ hierzu ist es vorgesehen, dass eine einzelne Antriebseinheit sowohl das erste Blendenelement als auch das zweite Blendenelement bewegt. Beispielsweise weist die Antriebseinheit ein Piezoelement, ein elektromagnetisches Bewegungselement und/oder ein Bimetall-Element auf. Als Piezoelement eignet bzw. eignen sich beispielsweise ein Biegepiezo-Element, ein Piezo-Trägheitsantrieb, ein Blockpiezo-Element und/oder ein Piezo-Krabbler. Als Bimetall-Element eignet sich jede Kombination aus Metallen, welche die benötige Bewegung bereitstellt, insbesondere nichtmagnetisch und im Ultrahochvakuum einsetzbar ist, ohne dieses stark zu beeinflussen. Die vorgenannte Aufzählung von Antriebseinheiten ist nicht abschließend. Vielmehr kann jede Antriebseinheit verwendet werden, die für die Erfindung geeignet ist.

Zur Versorgung und Steuerung der Antriebseinheit, beispielsweise des vorgenannten Piezoelements oder des vorgenannten elektromagnetischen Bewegungselements, ist beispielsweise eine Versorgungseinheit vorgesehen, welche die Antriebseinheit mit einer Spannung versorgt, mit welcher die Antriebseinheit gesteuert wird. Wenn die Antriebseinheit als Bimetall-Element ausgebildet ist, so ist eine Versorgungseinheit vorgesehen, welche der Antriebseinheit Wärme zuführt oder abführt. Die Versorgungseinheit ist beispielsweise in einer Hochspannungsversorgungseinheit des Teilchenstrahlgeräts angeordnet. Über eine Hochspannungsversorgungsleitung werden Steuersignale der Versorgungseinheit an die Antriebseinheit übertragen. Darüber hinaus ist es beispielsweise vorgesehen, dass die Antriebseinheit zur Steuerung mittels eines optischen Signals ausgelegt ist. Hierzu weist die Antriebseinheit beispielsweise einen optischen Sensor auf, welcher mittels eines Lichtstrahls zur Schaltung des optischen Sensors beleuchtet werden kann. Der optische Sensor steuert wiederum die Antriebseinheit. Wenn man den optischen Sensor an der Antriebseinheit nicht wünscht, dann sieht es eine weitere Ausführungsform der Erfindung vor, dass beispielsweise das als Antriebseinheit ausgebildete Bimetall-Element durch Einkoppeln eines Lichtstrahls (beispielsweise ein Laserstrahl) in das Teilchenstrahlgerät bestrahlt und beheizt wird, um so eine notwendige Biegung für einen Antrieb zu erzielen. Bei den vorgenannten Ausführungsformen ist von Vorteil, dass der Bauplatz zwischen dem Teilchenstrahlerzeuger und der ersten Kondensorlinse in der Regel gering ist und auf diese Weise eine Steuerung der Antriebseinheit möglich ist, ohne zusätzlichen Bauplatz für Steuerungszuleitungen bereitzustellen.

Bei einem weiteren Ausführungsbeispiel der Erfindung sind das erste Blendenelement und das zweite Blendenelement der ersten Blendeneinheit mittels eines federnden Verbindungselements verbunden. Beispielsweise ist es vorgesehen, dass das federnde Verbindungselement als ein Bimetall-Element ausgebildet ist. Bei diesem Ausführungsbeispiel kann die Antriebseinheit einen größeren Verstellweg aufweisen, als dieser zum Bewegen des ersten Blendenelements von dem ersten Anschlagelement zum zweiten Anschlagelement bzw. zum Bewegen des zweiten Blendenelements von dem dritten Anschlagelement zum vierten Anschlagelement überhaupt notwendig ist. Durch das federnde Verbindungselement wird der nicht benötigte Verstellweg kompensiert. Fehler bei der Einstellung des Verstellweges, insbesondere aufgrund mechanischer Ungenauigkeiten, können daher nicht mehr zu anderen Öffnungsgrößen der Blendenöffnung als zu den gewünschten Öffnungsgrößen führen. Bei einer Ausführungsform der Erfindung wird stets ein Verstellweg gewählt, der größer ist als der Weg, welcher das erste Blendenelement bzw. das zweite Blendenelement zwischen dem ersten und zweiten Anschlagelement bzw. dritten und vierten Anschlagelement zurücklegen muss. Nach Anlegen des ersten Blendenelements und des zweiten Blendenelements an dem ersten Anschlagelement oder dem zweiten Anschlagelement bzw. dem dritten Anschlagelement oder dem vierten Anschlagelement wird der nicht benötigte Verstellweg, den die Antriebseinheit noch bereitstellt, durch das federnde Verbindungselement aufgefangen (also kompensiert).

Bei einem weiteren Ausführungsbeispiel der Erfindung ist bzw. sind das erste Blendenelement und/oder das zweite Blendenelement zumindest teilweise federnd ausgebildet. Hierdurch wird genau dieselbe Wirkung und genau derselbe Vorteil erzielt, wie hinsichtlich des federnden Verbindungselements bereits weiter oben erläutert. Bei diesem Ausführungsbeispiel ist es insbesondere vorgesehen, dass das erste Blendenelement ein erstes Gelenkteil und ein zweites Gelenkteil aufweist, welche mittels einer ersten Gelenkstelle miteinander verbunden sind. Alternativ oder zusätzlich hierzu ist es vorgesehen, dass das zweite Blendenelement ein drittes Gelenkteil und ein viertes Gelenkteil aufweist, welche mittels einer zweiten Gelenkstelle miteinander verbunden sind. Beispielsweise ist (sind) die erste Gelenkstelle und/oder die zweite Gelenkstelle federnd ausgebildet. Die erste Gelenkstelle und/oder die zweite Gelenkstelle kann bzw. können jeweils als Festkörpergelenk ausgebildet sein. Das Festkörpergelenk zeichnet sich dadurch aus, dass es eine Stelle mit verminderter Biegesteifigkeit aufweist. Sie gewährleistet auch, dass das erste Gelenkteil und das zweite Gelenkteil stoffschlüssig miteinander verbunden sind. Entsprechendes gilt für das dritte Gelenkteil und das vierte Gelenkteil. Die verminderte Biegesteifigkeit wird in der Regel durch eine lokale Querschnittsverringerung bewirkt. Die Querschnittsverringerung kann dabei unterschiedliche geometrische Formen aufweisen. Festkörpergelenke weisen die Eigenschaft auf, dass sie eine Bewegung ohne weitere Wartung und ohne Reibung durchführen können.

Bei einem weiteren Ausführungsbeispiel der Erfindung ist (sind) das erste Blendenanschlagelement, das zweite Blendenanschlagelement, das erste Anschlagelement, das zweite Anschlagelement, das dritte Anschlagelement und/oder das vierte Anschlagelement als Exzenter ausgebildet. Auf diese Weise ist es möglich, die vorgenannten Anschlagelemente genau derart zu positionieren, dass eine gewünschte Öffnungsgröße der Blendenöffnung erzielt wird. Die Einstellung der Exzenter erfolgt beispielsweise vor Montage der ersten Blendeneinheit in das Teilchenstrahlgerät.

Bei einem weiteren Ausführungsbeispiel des Teilchenstrahlgeräts liegt die erste Blendeneinheit auf einem Potential im Bereich von 1 kV bis 20 kV gegenüber einem Massepotential, beispielsweise 5 kV bis 15 kV, insbesondere 8 kV. Das Massepotential ist beispielsweise das Potential des Gehäuses einer Probenkammer. Die erste Blendeneinheit liegt dabei auf demselben Potential wie eine Anode des Teilchenstrahlerzeugers. Auf diese Weise werden mit dem Teilchenstrahlerzeuger erzeugte Teilchen problemlos auf das Anodenpotential beschleunigt. Mittels einer Verzögerungseinrichtung, welche weiter unten noch näher erläutert wird, ist es dann möglich, die Teilchen auf ein gewünschtes Potential abzubremsen, welches für die weitere Untersuchung eines Objekts benötigt wird.

Ein Verfahren, mit dem eine gute Auflösung bei einer Bilderzeugung erzielbar ist, dient der Variation eines Strahlstroms eines Teilchenstrahls in einem Teilchenstrahlgerät, das einen Teilchenstrahlerzeuger zur Erzeugung eines Teilchenstrahls, eine Objektivlinse zur Fokussierung des Teilchenstrahls auf eine Probe, eine erste Kondensorlinse und eine zweite Kondensorlinse aufweist, wobei ausgehend von dem Teilchenstrahlerzeuger in Richtung der Objektivlinse gesehen zunächst die erste Kondensorlinse und dann die zweite Kondensorlinse angeordnet sind. Ferner weist das Teilchenstrahlgerät eine erste Blendeneinheit, die zwischen dem Teilchenstrahlerzeuger und der ersten Kondensorlinse angeordnet ist, und eine zweite Blendeneinheit auf, die zwischen der ersten Kondensorlinse und der zweiten Kondensorlinse angeordnet ist. Die erste Blendeneinheit weist eine Blendenöffnung mit veränderbarer Öffnungsgröße auf, wobei die Öffnungsgröße zumindest zwischen einer ersten Öffnungsgröße und einer zweiten Öffnungsgröße variierbar ist, wobei die erste Öffnungsgröße größer als die zweite Öffnungsgröße ist. Das Verfahren weist eine Veränderung einer Erregung der ersten Kondensorlinse auf, wobei bei einem ersten Strahlstrom (beispielsweise im Bereich von 10 nA bis einigen 100 nA) ein Crossover des Teilchenstrahls im Bereich der zweiten Blendeneinheit erzeugt wird (beispielsweise in unmittelbarer Nähe zur zweiten Blendeneinheit) und wobei bei einem zweiten Strahlstrom (beispielsweise im Bereich von 10 pA bis 1 nA) ein Crossover des Teilchenstrahls in einem vorgegebenen Abstand von der zweiten Blendeneinheit erzeugt wird, wobei der erste Strahlstrom größer als der zweite Strahlstrom ist. Wenn man den Abstand von einer Hauptebene der ersten Kondensorlinse zur zweiten Blendeneinheit als D und den Abstand des Crossover zu der Hauptebene der ersten Kondensorlinse als L definiert, gilt folgendes. Wenn

$$L < 0{,}45 \times D \quad \text{[Beziehung 1]},$$

dann wird das Teilchenstrahlgerät im Hochauflösungsmodus betrieben (Strahlstrom beispielsweise im Bereich von ungefähr 10 pA bis 500 pA). Wenn gilt

$$0{,}75 \times D < L < 1{,}25 \times D \quad \text{[Beziehung 2]},$$

dann wird das Teilchenstrahlgerät im Hochstrommodus betrieben (Strahlstrom beispielsweise im Bereich von 10 nA bis 300 nA). Wenn gilt

$$0{,}45 \times D < L < 0{,}75 \times D \quad \text{[Beziehung 3]},$$

dann wird das Teilchenstrahlgerät in einem Übergangsbereich betrieben, bei dem an einer geeigneten Stelle die erste Blendeneinheit mit einer großen Blendenöffnung gewählt werden sollte, wenn der Strahlstrom nicht begrenzt werden soll.

Ferner weist das Verfahren den Schritt auf, dass zur Reduzierung der Aufweitung von Energiebreite und virtueller Quellengröße bei dem zweiten Strahlstrom die erste Blendeneinheit auf die zweite Öffnungsgröße eingestellt wird. Durch Wechsel der Blendenöffnung von der ersten Öffnungsgröße auf die zweite Öffnungsgröße wird erzielt, dass Teilchen frühzeitig aus dem Teilchenstrahl ausgeblendet werden (nämlich an der ersten Blendeneinheit). Die Teilchen würden ansonsten an der zweiten Blendeneinheit ohnehin ausgeblendet. Auf diese Weise werden Wechselwirkungen von Teilchen des Teilchenstrahls untereinander, welche zwischen der ersten Blendeneinheit und der zweiten Blendeneinheit entstehen können, reduziert oder vermieden. Hierdurch wird die Auflösung bei der Bilderzeugung verbessert.

Mit größer werdendem L steigt der Strahlstrom und sinkt die Auflösung. Im Hochauflösungsmodus sinkt die Auflösung moderat (beispielsweise von 1,4 nm auf 2 nm bei einem steigenden Strahlstrom von 10 pA auf 500 pA). Im Hochstrommodus ist die Auflösung nicht mehr so gut. Beispielsweise liegt sie bei 5 nm. Sie kann sich aber durchaus noch weiter verschlechtern.

Bei einem weiteren Verfahren werden bei einem dritten Strahlstrom, welcher geringer als der erste Strahlstrom und größer als der zweite Strahlstrom ist, die erste Kondensorlinse und die zweite Kondensorlinse derart betrieben, dass zwischen dem Teilchenstrahlerzeuger und der Objektivlinse kein Crossover des Teilchenstrahls entsteht. Diese Einstellung wird auch Crossover-freier Modus genannt. Der Crossover-freie Modus überlappt mit dem Hochauflösungsmodus an dessen oberen Strahlstrombereich (200 pA bis 500 pA), beispielsweise wenn gilt

$$0{,}3 \times D < L < 0{,}45 \times D \quad \text{[Beziehung 4]}.$$

In dieser Überlappung zeigt der Crossover-freie Modus wegen des Fehlens des Crossovers eine etwas besser Auflösung als der Hochauflösungsmodus (wenn die beiden Modi mit demselben Strahlstrom verglichen werden). Für einen Strahlstrom kleiner als 200 pA, für den dann gilt

$$L < 0{,}3 \times D \quad \text{[Beziehung 5]},$$

ist nur noch der Betrieb im Hochauflösungsmodus möglich. In diesem Modus wird die beste Auflösung des Teilchenstrahlgeräts erzielt.

Die oben angegebenen Werte der Bereiche sind beispielhafte Werte. Diese können sich in Abhängigkeit von vorgebbaren Parametern verändern, beispielsweise der Arten der verwendeten Linsen und/oder der Blendendurchmesser.

Nachfolgend wird die Erfindung anhand von Ausführungsbeispielen mittels Figuren näher erläutert. Dabei zeigen

Fig. 1      eine schematische Darstellung eines SEM mit einer Blendeneinheit, deren Blendenöffnung verstellbar ist;

Fig. 2      eine schematische Darstellung eines ersten Beispiels einer Blendeneinheit mit verstellbarer Blendenöffnung;

Fig. 3 und 4      weitere Darstellungen der Blendeneinheit nach Figur 2;

Fig. 5      eine schematische Darstellung eines Anschlagelements;

Fig. 6      eine schematische Darstellung eines zweiten Beispiels einer Blendeneinheit mit verstellbarer Blendenöffnung;

Fig. 7      eine weitere schematische Darstellung des SEM der Figur 1 im Hoch- auflösungsmodus;

Fig. 8      eine weitere schematische Darstellung des SEM der Figur 1 im Hoch- strommodus;

Fig. 9      eine weitere schematische Darstellung des SEM der Figur 1, wobei ein Crossover-freier Strahlengang gewählt ist; sowie

Fig. 10      eine schematische Darstellung eines SEM mit einer weiteren Blen- deneinheit, deren Blendenöffnung verstellbar ist.

Die Erfindung wird mittels eines Teilchenstrahlgeräts in Form eines SEM näher erläutert. Es wird aber ausdrücklich darauf hingewiesen, dass die Erfindung nicht auf ein SEM eingeschränkt ist. Vielmehr kann die Erfindung bei jedem Teilchenstrahlgerät, insbesondere einem Ionenstrahlgerät, realisiert sein.

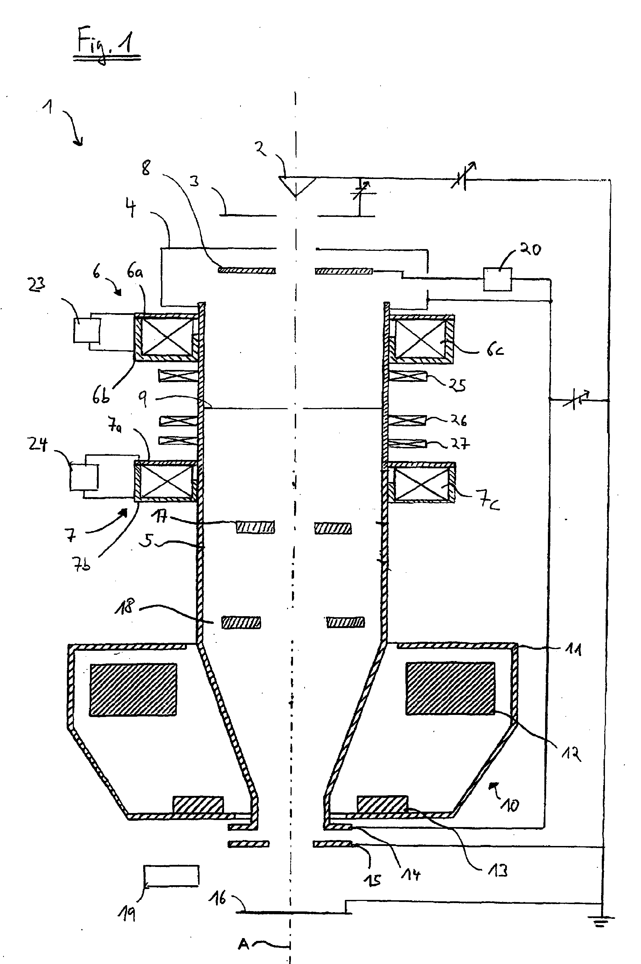

Figur 1 zeigt eine schematische Darstellung eines SEM 1. Das SEM 1 weist einen Strahlerzeuger in Form einer Elektronenquelle 2 (Kathode), eine Extraktionselektrode 3 sowie eine Anode 4 auf, die auf ein Ende eines Strahlführungsrohres 5 des SEM 1 aufgesetzt ist. Beispielsweise ist die Elektronenquelle 2 als ein thermischer Feldemitter ausgebildet. Die Erfindung ist allerdings nicht auf eine derartige Elektronenquelle eingeschränkt. Vielmehr ist jede Elektronenquelle verwendbar.

Elektronen, die aus der Elektronenquelle 2 austreten, bilden einen Primärelektronenstrahl. Die Elektronen werden aufgrund einer Potentialdifferenz zwischen der Elektronenquelle 2 und der Anode 4 auf Anodenpotential beschleunigt. Das Anodenpotential beträgt bei dem hier dargestellten Ausführungsbeispiel 1 kV bis 20 kV gegenüber einem Massepotential eines Gehäuses einer Probenkammer (nicht dargestellt), beispielsweise 5 kV bis 15 kV, insbesondere 8 kV, es könnte aber alternativ auch auf Massepotential liegen.

An dem Strahlführungsrohr 5 sind zwei Kondensorlinsen angeordnet, nämlich eine erste Kondensorlinse 6 und eine zweite Kondensorlinse 7. Dabei sind ausgehend von der Elektronenquelle 2 in Richtung einer Objektivlinse 10 zunächst die erste Kondensorlinse 6 und dann die zweite Kondensorlinse 7 angeordnet.

Die erste Kondensorlinse 6 weist einen ersten Polschuh 6a und einen zweiten Polschuh 6b auf, wobei ausgehend von der Elektronenquelle 2 in Richtung der Objektivlinse 10 gesehen zunächst der erste Polschuh 6a und dann der zweite Polschuh 6b angeordnet sind. Einen ähnlichen Aufbau weist die zweite Kondensorlinse 7 auf, bei der ein dritter Polschuh 7a und ein vierter Polschuh 7b vorgesehen sind. Ausgehend von der Elektronenquelle 2 in Richtung der Objektivlinse 10 gesehen sind zunächst der dritte Polschuh 7a und dann der vierte Polschuh 7b angeordnet. Der erste Polschuh 6a (bzw. dritte Polschuh 7a) wird häufig auch als oberer Polschuh bezeichnet, während der zweite Polschuh 6b (bzw. vierte Polschuh 7b) häufig auch als unterer Polschuh bezeichnet wird.

Zwischen der Anode 4 und der ersten Kondensorlinse 6 ist eine erste Blendeneinheit 8 angeordnet. Die erste Blendeneinheit 8 liegt zusammen mit der Anode 4 und dem Strahlführungsrohr 5 auf Hochspannungspotential, nämlich dem Potential der Anode 4 oder auf Masse. Zwischen der ersten Kondensorlinse 6 und der zweiten Kondensorlinse 7 ist eine ortsfeste zweite Blendeneinheit 9 angeordnet. Auf die Funktion und Wirkungen der ersten Kondensorlinse 6, der zweiten Kondensorlinse 7, der ersten Blendeneinheit 8 und der zweiten Blendeneinheit 9 wird weiter unten näher eingegangen.

Sowohl der erste Polschuh 6a als auch der zweite Polschuh 6b der ersten Kondensorlinse 6 sind über einen ersten Verstellmechanismus 23 unabhängig voneinander relativ zur zweiten Blendeneinheit 9 justierbar. Dies bedeutet, dass die relative Position des ersten Polschuhs 6a zur zweiten Blendeneinheit 9 einstellbar ist. Entsprechendes gilt für den zweiten Polschuh 6b. Auch der dritte Polschuh 7a und der vierte Polschuh 7b der zweiten Kondensorlinse 7 sind über einen zweiten Verstellmechanismus 24 gemeinsam oder unabhängig voneinander relativ zur zweiten Blendeneinheit 9 einstellbar.

In der ersten Kondensorlinse 6 ist eine erste Spule 6c angeordnet, während in der zweiten Kondensorlinse 7 eine zweite Spule 7c angeordnet ist. Mit Hilfe der ersten Spule 6c und der zweiten Spule 7c kann man die notwendige magnetische Erregung des ersten Polschuhs 6a sowie des zweiten Polschuhs 6b bzw. des dritten Polschuhs 7a und des vierten Polschuhs 7b erzielen.

Die Objektivlinse 10 weist Objektivlinsen-Polschuhe 11 auf, in denen eine Bohrung ausgebildet ist. Durch diese Bohrung ist das Strahlführungsrohr 5 geführt. In den Polschuhen 11 ist ferner eine dritte Spule 12 angeordnet. Hinter das Strahlführungsrohr 5 ist eine elektrostatische Verzögerungseinrichtung geschaltet. Diese weist eine einzelne Elektrode 15 und eine Rohrelektrode 14 auf, die an dem einer Probe 16 zugewandten Ende des Strahlführungsrohrs 5 ausgebildet ist. Somit liegt die Rohrelektrode 14 gemeinsam mit dem Strahlführungsrohr 5 auf dem Potential der Anode 4, während die einzelne Elektrode 15 sowie die Probe 16 auf einem gegenüber dem Potential der Anode 4 niedrigeren Potential liegen. Im vorliegenden Fall ist dies das Massepotential des Gehäuses der Probenkammer (nicht dargestellt). Auf diese Weise können die Elektronen des Primärelektronenstrahls auf eine gewünschte Energie abgebremst werden, die für die Untersuchung der Probe 16 erforderlich ist.

Das SEM 1 weist ferner Rastermittel 13 auf, durch die der Primärelektronenstrahl abgelenkt und über die Probe 16 gerastert werden kann. Die Elektronen des Primärelektronenstrahls treten dabei in Wechselwirkung mit der Probe 16. Als Folge der Wechselwirkung entsteht bzw. entstehen Wechselwirkungsteilchen und/oder Wechselwirkungsstrahlung, welche detektiert werden. Die auf diese Weise erhaltenen Detektionssignale werden ausgewertet.

Als Wechselwirkungsteilchen werden insbesondere Elektronen aus der Oberfläche der Probe 16 emittiert (sogenannte Sekundärelektronen) oder Elektronen des Primärelektronenstrahls zurückgestreut (sogenannte Rückstreuelektronen). Zur Detektion von Sekundärelektronen und/oder der Rückstreuelektronen ist eine Detektoranordnung im Strahlführungsrohr 5 angeordnet, die einen ersten Detektor 17 und einen zweiten Detektor 18 aufweist. Der erste Detektor 17 ist dabei entlang der optischen Achse A quellenseitig angeordnet, während der zweite Detektor 18 probenseitig entlang der optischen Achse A im Strahlungsführungsrohr 5 angeordnet ist. Ferner sind der erste Detektor 17 und der zweite Detektor 18 in Richtung der optischen Achse A des SEM 1 versetzt zueinander angeordnet. Sowohl der erste Detektor 17 als auch der zweite Detektor 18 weisen jeweils eine Durchgangsöffnung auf, durch die der Primärelektronenstrahl treten kann, und liegen annähernd auf dem Potential der Anode 4 und des Strahlführungsrohrs 5. Die optische Achse A des SEM 1 verläuft durch die jeweiligen Durchgangsöffnungen.

Der zweite Detektor 18 dient der Detektion derjenigen Elektronen, die unter einem relativ großen Raumwinkel aus der Probe 16 austreten. Dabei handelt es sich in erster Linie um Sekundärelektronen. An der Probe 16 zurückgestreute Elektronen (Rückstreuelektronen), die im Vergleich zu den Sekundärelektronen eine relativ hohe kinetische Energie beim Austritt aus der Probe 16 aufweisen, werden dagegen vom zweiten Detektor 18 nur zu einem sehr geringen Anteil erfasst, da die Rückstreuelektronen relativ nahe zur optischen Achse A von der Objektivlinse 10 fokussiert werden und somit durch die Durchgangsöffnung des zweiten Detektors 18 durchtreten können. Der erste Detektor 17 dient daher zur Erfassung der Rückstreuelektronen. Die mit dem ersten Detektor 17 und dem zweiten Detektor 18 erzeugten Detektionssignale werden verwendet, um ein Bild oder Bilder der Oberfläche der Probe 16 zu erzeugen.

Es wird explizit darauf hingewiesen, dass die Blendenöffnungen der ersten Blendeneinheit 8 und der zweiten Blendeneinheit 9 sowie die Durchgangsöffnungen des ersten Detektors 17 und des zweiten Detektors 18 übertrieben dargestellt sind. Die Durchgangsöffnungen des ersten Detektors 17 und des zweiten Detektors 18 haben eine längste Ausdehnung im Bereich 1 mm bis 5 mm. Beispielsweise sind sie kreisförmig ausgebildet und weisen einen Durchmesser im Bereich von 1 mm bis 3 mm auf. Auf die Größe der Blendenöffnungen der ersten Blendeneinheit 8 und der zweiten Blendeneinheit 9 wird weiter unten noch näher eingegangen.

Die zweite Blendeneinheit 9 ist bei dem hier dargestellten Ausführungsbeispiel als Lochblende ausgestaltet und ist mit einer Öffnung für den Durchtritt des Primärelektronenstrahls versehen, welche eine Ausdehnung im Bereich von 25 $\mu$m bis 50 $\mu$m aufweist, beispielsweise 35 $\mu$m. Die zweite Blendeneinheit 9 ist als eine Druckstufenblende ausgebildet. Sie trennt einen ersten Bereich, in welchem die Elektronenquelle 2 angeordnet ist und in welchem ein Ultrahochvakuum herrscht ($10^{-6}$ bis $10^{-10}$ Pa), von einem zweiten Bereich, der ein Hochvakuum aufweist ($10^{-1}$ bis $10^{-5}$ Pa). Der zweite Bereich ist der Zwischendruckbereich des Strahlführungsrohrs 5, welcher zur Probenkammer (nicht dargestellt) hinführt. Auch hierauf wird weiter unten noch näher eingegangen.

Neben der Bilderzeugung gibt es bei dem SEM 1 weitere Untersuchungsverfahren, die zur Untersuchung der Probe 16 verwendet werden können. Hierzu zählt das so genannte EBSD-Verfahren ("Electron Backscattered Diffraction"), bei dem die Beugungsmuster der Streuelektronen ermittelt werden. Ein weiteres Untersuchungsverfahren basiert auf der Detektion von Kathodolumineszenzlicht, das bei Einfall des Primärelektronenstrahls auf die Probe 16 aus der Probe 16 austritt. Weitere Untersuchungsverfahren sind beispielsweise die Untersuchung mittels energiedispersiver Röntgenspektroskopie (EDX) und die Untersuchung mittels wellenlängen-dispersiver Röntgenspektroskopie (WDX). Für diese weiteren Untersuchungsverfahren ist mindestens ein dritter Detektor 19 vorgesehen, der im Bereich zwischen dem Strahlführungsrohr 5 und der Probe 16 angeordnet ist. Es können auch weitere dritte Detektoren 19 vorgesehen sein (nicht dargestellt).

Wie oben bereits erwähnt, sollte zur Erzielung einer ausreichend guten Auflösung der Bilder der Oberfläche der Probe 16 das SEM 1 im Hochauflösungsmodus betrieben werden. Hingegen benötigt man für die weiteren Untersuchungsverfahren hohe Zählraten, so dass das SEM 1 im Hochstrommodus betrieben werden sollte.

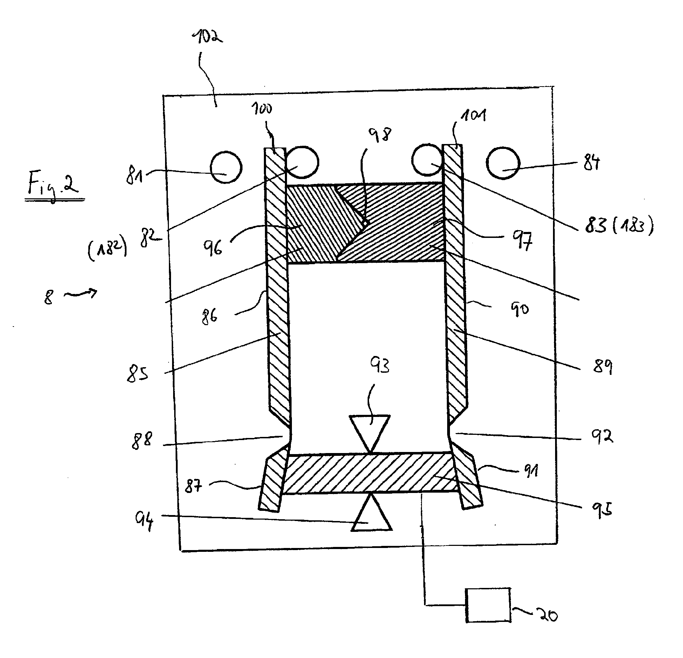

Um zwischen den beiden Modi (Hochauflösungsmodus und Hochstrommodus) hin-und herschalten zu können, wird zunächst die erste Kondensorlinse 6 entsprechend erregt. Hierdurch wird der Strahlstrom beispielsweise in einem Bereich von 10 pA bis 300 nA kontinuierlich variiert. Im Hochauflösungsmodus ist es nun auch möglich, eine andere Blendenöffnung der ersten Blendenöffnung 8 zu wählen, um so Elektronen frühzeitig aus dem Primärelektronenstrahl auszublenden, die ansonsten an der zweiten Blendeneinheit 9 ohnehin ausgeblendet werden. Die Figuren 2 bis 4 zeigen eine Form der ersten Blendeneinheit 8 in schematischen Darstellungen, wie sie bei dem SEM 1 gemäß Figur 1 vorgesehen ist und verwendet wird. Die erste Blendeneinheit 8 weist ein erstes Blendenelement 85 auf, welches mit einem ersten Gelenkteil 86 und einem zweiten Gelenkteil 87 versehen ist. Das erste Gelenkteil 86 und das zweite Gelenkteil 87 sind mittels einer ersten Gelenkstelle 88 miteinander verbunden. Zusätzlich ist bei der ersten Blendeneinheit 8 ein zweites Blendenelement 89 vorgesehen, welches ein drittes Gelenkteil 90 und ein viertes Gelenkteil 91 aufweist. Das dritte Gelenkteil 90 und das vierte Gelenkteil 91 sind mittels einer zweiten Gelenkstelle 92 miteinander verbunden.

Die erste Gelenkstelle 88 und die zweite Gelenkstelle 92 sind federnd und jeweils als Festkörpergelenk ausgebildet. Das Festkörpergelenk zeichnet sich dadurch aus, dass es eine Stelle mit verminderter Biegesteifigkeit aufweist. Sowohl die erste Gelenkstelle 88 als auch die zweite Gelenkstelle 92 weisen jeweils eine Bewegungsachse auf, welche im Wesentlichen parallel zur optischen Achse A des SEM 1 verläuft. Die optische Achse A steht senkrecht auf der Blattebene der Figuren 2 bis 4.

Zwischen dem zweiten Gelenkteil 87 des ersten Blendenelements 85 und dem vierten Gelenkteil 91 des zweiten Blendenelements 89 ist ein Piezoelement 95 angeordnet, welches durch ein erstes Befestigungselement 93 und ein zweites Befestigungselement 94 gehalten ist. Das Piezoelement 95 ist als Biegepiezo-Element (also als ein Biegeaktuator) ausgebildet. Es wird aber explizit darauf hingewiesen, dass die Erfindung nicht auf ein Biegepiezo-Element eingeschränkt ist. Vielmehr ist jede geeignete Antriebseinheit verwendbar, beispielsweise ein Piezo-Trägheitsantrieb, ein Blockpiezo-Element und/oder ein Piezo-Krabbler. Das Piezoelement 95 ist mit einer Steuer- und Versorgungseinrichtung 20 verbunden, welche auch in Figur 1 dargestellt ist. Die Steuer- und Versorgungseinrichtung 20 ist derart angeordnet und geschaltet, dass deren Steuer- und Versorgungssignale der Anodenspannung überlagert werden, auf welcher die erste Blendeneinheit 8 liegt.

An dem ersten Gelenkteil 86 der ersten Blendeneinheit 8 ist ein erstes Begrenzungselement 96 angeordnet. Ähnliches gilt für das dritte Gelenkteil 90 des zweiten Blendenelements 89. Dort ist ein zweites Begrenzungselement 97 angeordnet. Sowohl das erste Begrenzungselement 96 als auch das zweite Begrenzungselement 97 weisen jeweils einen V-förmigen Abschnitt auf, die zur Bildung einer Blendenöffnung 98 zusammenwirken. Das erste Begrenzungselement 96 und das zweite Begrenzungselement 97 überlappen einander und können in zueinander gegensätzliche Richtungen bewegt werden. Auf diese Weise wird die Größe der Blendenöffnung 98 eingestellt, wie weiter unten noch näher erläutert wird.

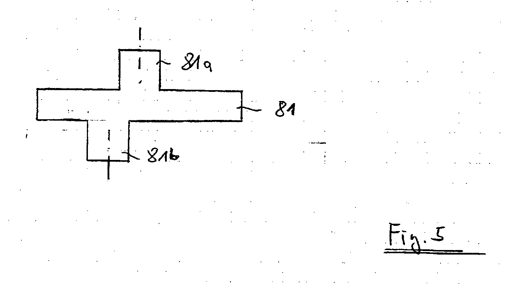

Im Bereich eines ersten Endes 100 des ersten Gelenkteils 86 sind ein erstes Anschlagelement 81 und ein zweites Anschlagelement 82 angeordnet. Ferner sind im Bereich eines zweiten Endes 101 des dritten Gelenkteils 90 ein drittes Anschlagelement 83 und ein viertes Anschlagelement 84 angeordnet. Figur 5 zeigt das erste Anschlagelement 81 in einer schematischen Darstellung. Die weiteren Anschlagelemente sind baugleich. Das erste Anschlagelement 81 ist als Exzenter ausgebildet und weist ein Begrenzungsteil 81a und ein Führungselement 81b auf. Das Führungselement 81 b ist in einer Grundplatte 102 montiert, welche in den Figuren 2 bis 4 schematisch dargestellt ist. An dieser Grundplatte 102 sind die vorgenannten Anschlagelemente 81 bis 84, das erste Befestigungselement 93 sowie das zweite Befestigungselement 94 angeordnet.

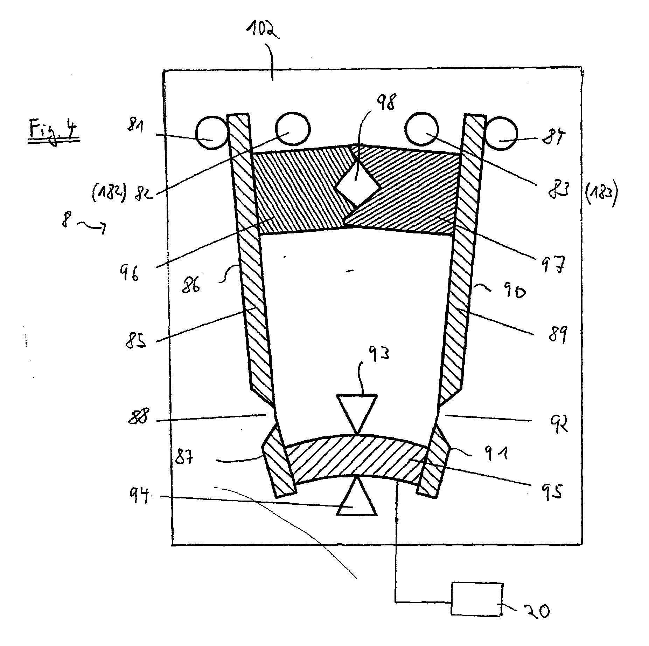

Wie in den Figuren 2 und 4 dargestellt, sind zwei Einstellungen gegeben, bei denen zum einen das erste Gelenkteil 86 an dem zweiten Anschlagelement 82 und das dritte Gelenkteil 90 an dem dritten Anschlagelement 83 anliegen (Figur 2), und zum anderen das erste Gelenkteil 86 an dem ersten Anschlagelement 81 und das dritte Gelenkteil 90 an dem vierten Anschlagelement 84 anliegen (Figur 4). Diese beiden Einstellungen stellen die Blendenöffnung 98 mit einer ersten Öffnungsgröße (Figur 2) und mit einer zweiten Öffnungsgröße (Figur 4) zur Verfügung. Dabei wird vorstehend und auch nachstehend unter einer Öffnungsgröße eine eindimensionale Größe (Ausdehnung) verstanden, welche den Durchmesser einer der Blendenöffnungen oder den maximalen Abstand eines Randes des ersten Begrenzungselements 96 zu einem Rand des zweiten Begrenzungselements 97 beschreibt. Durch die Ausbildung des ersten Anschlagelements 81, des zweiten Anschlagelements 82, des dritten Anschlagelements 83 und des vierten Anschlagelements 84 als Exzenter ist es möglich, die vorgenannten Anschlagselemente genau derart zu positionieren, dass eine gewünschte Öffnungsgröße der Blendenöffnung 98 (erste Öffnungsgröße oder zweite Öffnungsgröße) erzielt wird, wobei die erste Öffnungsgröße und die zweite Öffnungsgröße jeweils durch die größte Ausdehnung der Blendenöffnung 98 in einer Richtung gegeben sind. Die Einstellung der vorgenannten Anschlagelemente erfolgt dabei beispielsweise vor Montage der ersten Blendeneinheit 8 in das SEM 1. Die erste Öffnungsgröße und die zweite Öffnungsgröße liegen beispielsweise im Bereich von ungefähr 10 μm bis 500 μm. Ferner ist die zweite Öffnungsgröße größer als die erste Öffnungsgröße gewählt (oder umgekehrt). Beispielsweise ist die erste Öffnungsgröße 50 μm und die zweite Öffnungsgröße 200 μm.

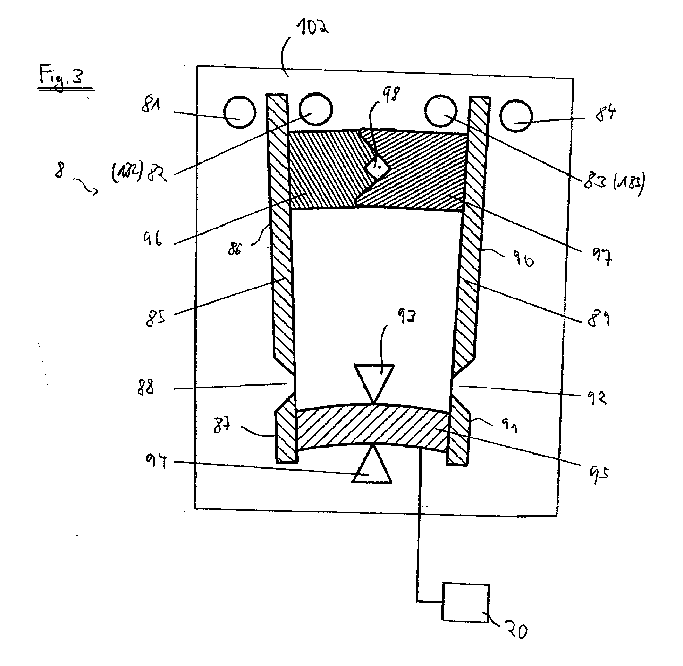

Bei dem SEM 1 ist es nun durch Steuerung des Piezoelements 95 möglich, durch Bewegen des ersten Blendenelements 85 und des zweiten Blendenelements 89 zwischen der ersten Öffnungsgröße und der zweiten Öffnungsgröße hin- und herzuschalten. Figur 2 zeigt das Piezoelement 95 in einem nicht erregten Zustand. In diesem Zustand sind die erste Gelenkstelle 88 und die zweite Gelenkstelle 92 derart vorgespannt, dass das erste Gelenkteil 86 an dem zweiten Anschlagelement 82 und das dritte Gelenkteil 90 an dem dritten Anschlagelement 83 anliegt. Das erste Begrenzungselement 96 und das zweite Begrenzungselement 97 überlappen einander und wirken derart zusammen, dass die Blendenöffnung 98 die erste Öffnungsgröße einnimmt. Figur 3 zeigt einen Übergangszustand. In diesem Zustand wurde das Piezoelement 95 derart erregt, dass es sich leicht biegt. Hierdurch wird das erste Gelenkteil 86 derart bewegt, dass es sich zwischen dem ersten Anschlagelement 81 und dem zweiten Anschlagelement 82 befindet. Ferner wird das dritte Gelenkteil 90 derart bewegt, dass es sich zwischen dem dritten Anschlagelement 83 und dem vierten Anschlagelement 84 befindet. Die erste Gelenkstelle 88 und die zweite Gelenkstelle 92 sind entspannt. Figur 4 zeigt wiederum einen Zustand, bei dem das Piezoelement 95 derart erregt und gebogen ist, dass das erste Gelenkteil 86 an dem ersten Anschlagelement 81 anliegt und dass das dritte Gelenkteil 90 an dem vierten Anschlagelement 84 anliegt. Die erste Gelenkstelle 88 und die zweite Gelenkstelle 92 sind wiederum gespannt. Das erste Begrenzungselement 96 und das zweite Begrenzungselement 97 überlappen einander und wirken derart zusammen, dass die Blendenöffnung 98 die zweite Öffnungsgröße einnimmt.

Wie oben erwähnt, sind die erste Gelenkstelle 88 und die zweite Gelenkstelle 92 federnd ausgebildet. Ferner ist es vorgesehen, dass das Piezoelement 95 derart erregt wird, dass der zur Verfügung gestellte Verstellweg größer ist, als der eigentlich zur Verstellung des ersten Gelenkteils 86 und des zweiten Gelenkteils 90 zwischen den jeweiligen Anschlagelementen benötigte Weg. Nach Anlegen des ersten Gelenkteils 86 an dem ersten Anschlagselement 81 bzw. dem zweiten Anschlagelement 82 und nach Anlegen des dritten Gelenkteils 90 an dem dritten Anschlagselement 83 bzw. dem vierten Anschlagselement 84 wird der nicht benötigte Verstellweg, den das Piezoelement 95 durch Verbiegung noch bereitstellt, durch die federnde Ausbildung aufgefangen (also kompensiert). Fehler aufgrund mechanischer Ungenauigkeiten, die zu anderen Öffnungsgrößen der Blendenöffnung als zu der ersten Öffnungsgröße oder der zweiten Öffnungsgröße führen, werden hierdurch vermieden.

Wie oben bereits erwähnt, ist der Strahlstrom des Primärelektronenstrahls kontinuierlich über einen vorgebbaren Bereich einstellbar, beispielsweise in einem Bereich von 10 pA bis 300 nA. Dies wird dadurch erzielt, dass die Erregung der ersten Kondensorlinse 6 variiert wird.

Die zweite Blendeneinheit 9 ist als Druckstufenblende ausgebildet, wie oben bereits erwähnt. Durch die zweite Blendeneinheit 9 wird verhindert, dass sich das Ultrahochvakuum des ersten Bereichs durch Verschmutzungen aus dem zweiten Bereich, beispielsweise aufgrund von Einführung von Gasen im Bereich der Probe, verschlechtert.

Damit der Verlauf des Primärelektronenstrahls stets modusunabhängig bleibt, ist es vorgesehen, sowohl den ersten Polschuh 6a als auch den zweiten Polschuh 6b der ersten Kondensorlinse 6 relativ zur zweiten Blendeneinheit 9 mittels des ersten Verstellmechanismus 23 zu justieren. Die Justierung erfolgt dabei für den ersten Polschuh 6a und den zweiten Polschuh 6b unabhängig voneinander. Überlegungen haben ergeben, dass eine Justierung der ersten Kondensorlinse 6 als Ganzes (also eine Justierung des ersten Polschuhs 6a und des zweiten Polschuhs 6b stets miteinander) nicht ausreicht, um einen modusunabhängigen Strahlverlauf zu erhalten. Vielmehr kommt es wirklich darauf an, dass der erste Polschuh 6a und der zweite Polschuh 6b unabhängig voneinander justiert werden.

Um einem besonders guten und modusunabhängigen Strahlverlauf des Primärelektronenstrahls zu erhalten, ist es bei diesem Ausführungsbeispiel vorgesehen, dass der dritte Polschuh 7a und der vierte Polschuh 7b der zweiten Kondensorlinse 7 gemeinsam oder unabhängig voneinander relativ zur zweiten Blendeneinheit 9 mittels des zweiten Verstellmechanismus 24 justierbar sind. Alternativ hierzu ist es vorgesehen, den Primärelektronenstrahl im Bereich zwischen der zweiten Blendeneinheit 9 und der Probe 16 mittels eines Ablenksystems bestehend aus einer ersten Ablenkeinheit 25, einer zweiten Ablenkeinheit 26 und einer dritten Ablenkeinheit 27 derart auszulenken, dass ein modusunabhängiger Strahlverlauf erzielbar ist. Es wird aber explizit darauf hingewiesen, dass die Erfindung nicht auf die vorgenannte Anzahl an Ablenkeinheiten eingeschränkt ist. Vielmehr können auch nur eine Ablenkeinheit oder zwei Ablenkeinheiten oder sogar mehr als drei Ablenkeinheiten vorgesehen sein.

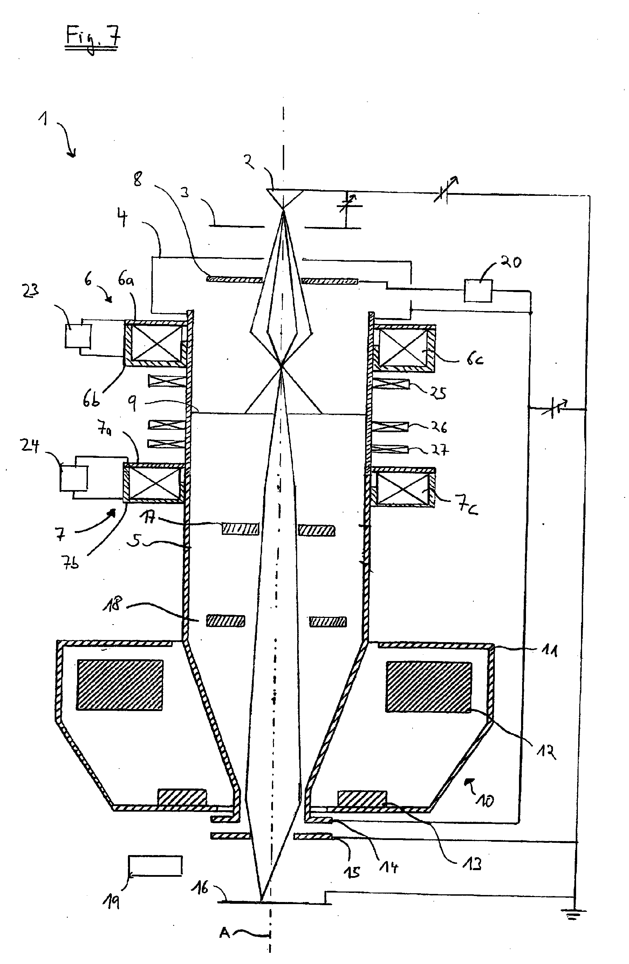

Figur 7 zeigt das SEM 1 gemäß der Figur 1 mit einem Teil des Strahlengangs des Primärelektronenstrahls. Der Durchmesser des Teilchenbündels ist hier und in den folgenden Figuren übertrieben groß dargestellt. Das SEM 1 befindet sich in Figur 7 im Hochauflösungsmodus. Die erste Kondensorlinse 6 wird derart erregt, dass ein Crossover des Primärelektronenstrahls relativ nah zur Elektronenquelle 2 angeordnet ist. Wenn man den Abstand von einer Hauptebene der ersten Kondensorlinse 6 zur zweiten Blendeneinheit 9 als D und den Abstand des Crossover zu der Hauptebene der ersten Kondensorlinse 6 als L definiert, gilt im Hochauflösungsmodus

$$L < 0,45 \times D \quad \text{[Beziehung 1]},$$

wobei der Strahlstrom beispielsweise im Bereich von ungefähr 10 pA bis 500 pA liegt. Gleichzeitig wird bei der ersten Blendeneinheit 8 eine kleine Blendenöffnung gewählt. Auf diese Weise wird bereits an der ersten Blendeneinheit 8 ein großer Teil des Primärelektronenstrahls ausgeblendet, der sonst sowieso an der zweiten Blendeneinheit 9 ausgeblendet werden würde. Man erreicht dadurch, dass die Wechselwirkungen der im Primärelektronenstrahl verbleibenden Elektronen untereinander derart vernachlässigbar sind, dass eine Aufweitung des Primärelektronenstrahls vermieden wird. Man kann demnach eine gute Auflösung bei Erzeugung eines Bildes erhalten.

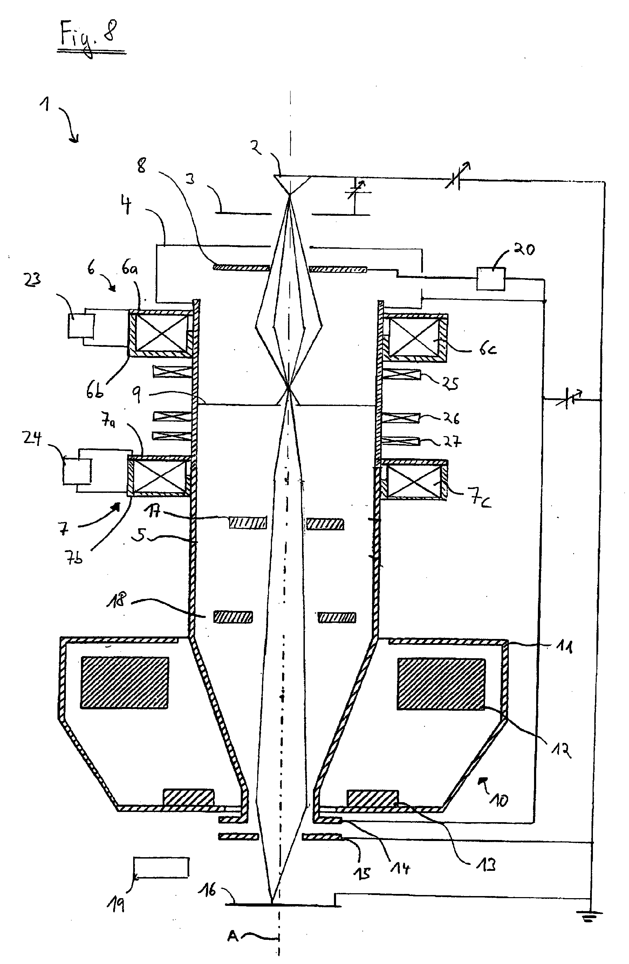

Figur 8 zeigt das SEM 1 der Figur 1 wiederum mit einem Teil des Strahlengangs des Primärelektronenstrahls im Hochstrommodus. Die erste Kondensorlinse 6 wird derart erregt, dass ein Crossover des Primärelektronenstrahls in der Nähe der zweiten Blendeneinheit 9 erzielt wird. Dabei liegt der Crossover zwischen der ersten Kondensorlinse 6 und der zweiten Blendeneinheit 9. Alternativ hierzu ist es aber auch möglich, den Crossover zwischen der zweiten Blendeneinheit 9 und der zweiten Kondensorlinse 7 anzuordnen. Auf diese Weise ist es möglich, einen großen Teil des Primärelektronenstrahls durch die zweite Blendeneinheit 9 treten zu lassen. Im Hochstrommodus gilt

$$0,75 \times D < L < 1,25 \times D \quad \text{[Beziehung 2]},$$

wobei der Strahlstrom beispielsweise im Bereich von 10 nA bis 300 nA liegt.

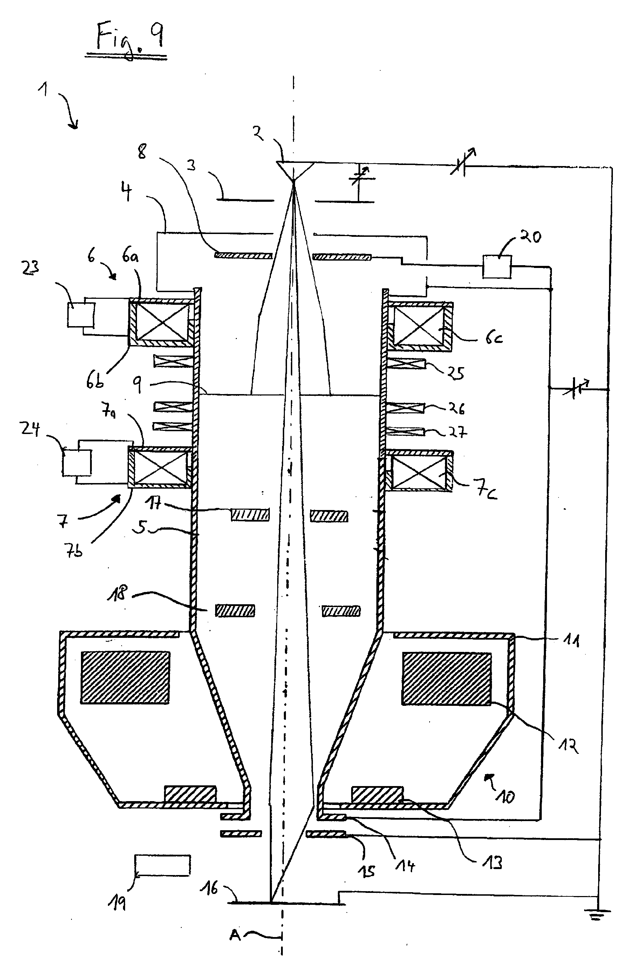

Figur 9 zeigt das SEM 1 der Figur 1 wiederum mit einem Teil des Strahlengangs des Primärelektronenstrahls, wobei hier ein Strahlstrom derart gewählt ist, dass er zwischen einem hohen Strom und einem niedrigen Strom liegt. Dies ist ein Übergangsbereich zwischen dem Hochstrommodus und dem Hochauflösungsmodus. Bei diesem Ausführungsbeispiel werden die erste Kondensorlinse 6 und die zweite Kondensorlinse 7 derart betrieben, dass zwischen der Elektronenquelle 2 und der Objektivlinse 10 kein Crossover des Primärelektronenstrahls entsteht. In dem in Figur 9 dargestellten Crossover-freien Modus überlappt dieser etwas mit dem Hochauflösungsmodus an dessen oberen Strahlstrombereich (200 pA bis 500 pA), beispielsweise wenn gilt

$$0{,}3 \times D < L < 0{,}45 \times D \quad \text{[Beziehung 4]}.$$

In dieser Überlappung zeigt der Crossover-freie Modus wegen des Fehlens des Crossovers eine etwas besser Auflösung als der Hochauflösungsmodus (wenn die beiden Modi mit demselben Strahlstrom verglichen werden). Für einen Strahlstrom kleiner als 200 pA, für den dann gilt

$$L < 0{,}3 \times D \quad \text{[Beziehung 5]},$$

ist nur noch der Betrieb im Hochauflösungsmodus möglich.

Die Einstellung des Strahlstroms des Primärelektronenstrahls erfolgt in Abhängigkeit von der Untersuchungsmethode, die angewendet werden soll. Falls ein Bild der Oberfläche der Probe 16 erzeugt werden soll, kann der Hochauflösungsmodus des SEM 1 eingestellt werden. Hierzu wird dann ein Strahlstrom im Bereich von beispielsweise 10 pA bis 1 nA gewählt. Will man aber im Hochstrommodus arbeiten, um beispielsweise die weiter oben genannten weiteren Untersuchungsverfahren anzuwenden, wählt man einen Strahlstrom beispielsweise im Bereich von 10 nA bis einigen 100 nA.

Die zweite Kondensorlinse 7 weist bei dem SEM 1 die Funktion auf, den Durchmesser des Primärelektronenbündels in der Objektivlinse 10 derart einzustellen, dass für einen gewählten Strahlstrom eine gute laterale Auflösung erzielt wird.

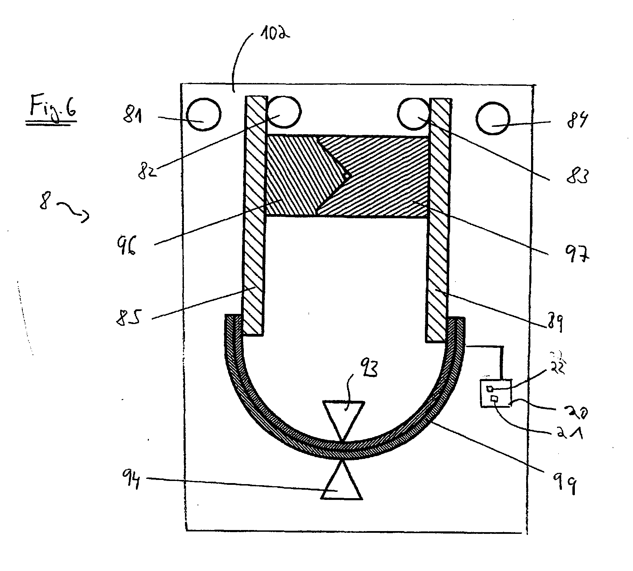

Figur 6 zeigt ein weiteres Beispiel der ersten Blendeneinheit 8. Die Blendeneinheit 8 ähnelt den Figuren 2 bis 4. Gleiche Bauteile sind mit gleichen Bezugszeichen versehen. Im Unterschied zu den Figuren 2 bis 4 weisen das erste Blendenelement 85 und das zweite Blendenelement 89 keine Gelenkteile auf. Vielmehr sind das erste Blendenelement 85 und das zweite Blendenelement 89 über ein Bimetall-Element 99 miteinander verbunden. Das Bimetall-Element 99 ist wiederum mit einer Steuer- und Versorgungseinrichtung 20 verbunden. Die Steuer- und Versorgungseinrichtung 20 weist einen optischen Sensor 21 und ein Heiz- und Kühlelement 22 auf. Durch Einfall von Licht auf den optischen Sensor 21 kann das Heiz- und Kühlelement 22 geschaltet werden, welches wiederum das Bimetall-Element 99 steuert. In Abhängigkeit einer Zufuhr von Wärme und Kälte kann sich das Bimetall-Element 99 verbiegen und bewegt hierdurch das erste Blendenelement 85 und das zweite Blendenelement 89 in die Positionen an den Anschlagelementen, um die erste Öffnungsgröße oder die zweite Öffnungsgröße der Blendenöffnung 98 zu erzielen. Die Verwendung des optischen Sensors 21 ist deshalb von Vorteil, da der Bauplatz zwischen der Elektronenquelle 2 und der ersten Kondensorlinse 6 gering ist und auf diese Weise eine Steuerung des Bimetall-Elements 99 möglich ist, ohne zusätzlichen Bauplatz für Steuerungszuleitungen bereitzustellen. Das in Figur 6 dargestellte Bimetall-Element 99 ist federnd ausgebildet und stellt dieselbe Wirkung und denselben Vorteil zur Verfügung wie hinsichtlich der federnden Ausbildung der ersten Gelenkstelle 88 und der zweiten Gelenkstelle 92 besprochen. Wenn man die Steuer- und Versorgungseinheit 20 nicht an der Grundplatte 102 anordnen will, um das Vakuum in diesem Bereich nicht zu verschlechtern, dann sieht es eine weitere Form vor, dass das Bimetall-Element 99 durch Einkoppeln eines Lichtstrahls (beispielsweise ein Laserstrahl) in das SEM 1 bestrahlt und beheizt wird, um so eine notwendige Biegung für einen Antrieb zu erzielen.

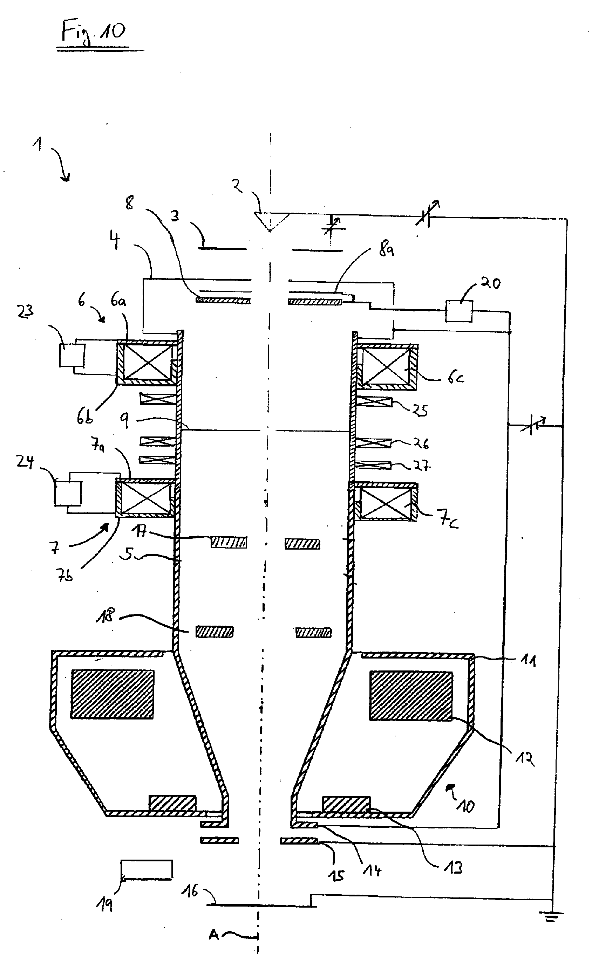

Figur 10 zeigt ein weiteres Ausführungsbeispiel des SEM 1. Das SEM 1 der Figur 10 entspricht dem SEM 1 der Figur 1. Gleiche Bauteile sind mit gleichen Bezugszeichen versehen. Im Unterschied zu dem Ausführungsbeispiel gemäß der Figur 1 weist die erste Blendeneinheit 8 eine Lochblendeneinheit 8a auf, welche zwischen der Anode 4 und der ersten Blendeneinheit 8 angeordnet ist. Die Lochblendeneinheit 8a stellt eine Blendenöffnung mit einer ersten Öffnungsgröße zur Verfügung, während die erste Blendeneinheit 8 eine Blendenöffnung mit einer zweiten Öffnungsgröße und einer dritten Öffnungsgröße zur Verfügung stellt. Die erste Öffnungsgröße ist deutlich größer als die dritte Öffnungsgröße. Die erste Öffnungsgröße ist kleiner als die zweite Öffnungsgröße. Bei dieser Ausführungsform entspricht die erste Blendeneinheit 8 der Ausführungsform gemäß den Figuren 2 bis 4 , wobei an der ersten Blendeneinheit 8 für das erste Blendenelement 85 nur das erste Blendenanschlagelement 182 und für das zweite Blendenelement 89 nur das zweite Blendenanschlagelement 183 vorgesehen sind. Diese reichen aus, um das erste Blendenelement 85 und das zweite Blendenelement 89 derart zu bewegen, dass die erste Öffnungsgröße (dies ist die tatsächlich erzielte effektive Öffnung) oder die dritte Öffnungsgröße erzielt wird. Die vorgenannte Ausführungsform weist den Vorteil auf, dass Streuelektronen im Bereich des ersten Begrenzungselements 96 und des zweiten Begrenzungselements 97 fast vollständig vermieden werden. Alternativ kann die erste Öffnungsgröße auch etwas größer als oder etwa gleich groß wie die zweite Öffnungsgröße sein. Bei dieser Ausführungsform werden statt des ersten Blendenanschlagelements 182 und des zweiten Blendenanschlagelements 183 dann wieder das erste Anschlagelement 81, das zweite Anschlagelement 82, das dritte Anschlagelement 83 und das vierte Anschlagelement 84 benötigt. Durch Bewegen des ersten Blendenelements 85 und des zweiten Blendenelements 89 kann man nun die zweite Öffnungsgröße oder die dritte Öffnungsgröße erzielen. Bei dieser Ausführungsform werden Streuelektronen im Bereich des ersten Begrenzungselements 96 und des zweiten Begrenzungselements 97 zumindest weitestgehend vermieden.

**Bezugszeichenliste**

| | |
|---|---|
| 1 | SEM (Rasterelektronenmikroskop) |
| 2 | Elektronenquelle |
| 3 | Extraktionselektrode |
| 4 | Anode |
| 5 | Strahlführungsrohr |
| 6 | erste Kondensorlinse |
| 6a | erster Polschuh |
| 6b | zweiter Polschuh |
| 6c | erste Spule |
| 7 | zweite Kondensorlinse |
| 7a | dritter Polschuh |
| 7b | vierter Polschuh |
| 7c | zweite Spule |
| 8 | erste Blendeneinheit |
| 9 | zweite Blendeneinheit |
| 10 | Objektivlinse |
| 11 | Objektivlinsen-Polschuh |
| 12 | dritte Spule |
| 13 | Rastermittel |
| 14 | Rohrelektrode |
| 15 | Elektrode |
| 16 | Probe |
| 17 | erster Detektor |
| 18 | zweiter Detektor |
| 19 | dritter Detektor |
| 20 | Steuer- und Versorgungseinheit |
| 21 | optischer Sensor |
| 22 | Heiz- und Kühlelement |
| 23 | erster Verstellmechanismus |
| 24 | zweiter Verstellmechanismus |
| 25 | erste Ablenkeinheit |
| 26 | zweite Ablenkeinheit |
| 27 | dritte Ablenkeinheit |
| A | optische Achse |
| 81 | erstes Anschlagelement |
| 81a | Begrenzungsteil |
| 81b | Führungselement |
| 82 | zweites Anschlagelement |
| 83 | drittes Anschlagelement |
| 84 | viertes Anschlagelement |
| 85 | erstes Blendenelement |
| 86 | erstes Gelenkteil |
| 87 | zweites Gelenkteil |
| 88 | erste Gelenkstelle |
| 89 | zweites Blendenelement |
| 90 | drittes Gelenkteil |
| 91 | viertes Gelenkteil |
| 92 | zweite Gelenkstelle |
| 93 | erstes Befestigungselement |
| 94 | zweites Befestigungselement |
| 95 | Piezoelement |

96     erstes Begrenzungselement
97     zweites Begrenzungselement
98     Blendenöffnung
99     Bimetall-Element
100    erstes Ende
101    zweites Ende
102    Grundplatte
182    erstes Blendenanschlagelement
183    zweites Blendenanschlagelement

**Patentansprüche**

1. Teilchenstrahlgerät (1), mit

    - einem Teilchenstrahlerzeuger (2) zur Erzeugung von Teilchen, welche einen Teilchenstrahl bilden,
    - einer Objektivlinse (10) zur Fokussierung des Teilchenstrahls auf eine Probe (16),
    - einer ersten Kondensorlinse (6, 6a, 6b, 6c) und einer zweiten Kondensorlinse (7, 7a, 7b, 7c), wobei ausgehend von dem Teilchenstrahlerzeuger (2) in Richtung der Objektivlinse (10) gesehen zunächst die erste Kondensorlinse (6, 6a, 6b, 6c) und dann die zweite Kondensorlinse (7, 7a, 7b, 7c) angeordnet sind,
    - einer ersten Blendeneinheit (8), die zwischen dem Teilchenstrahlerzeuger (2) und der ersten Kondensorlinse (6, 6a, 6b, 6c) angeordnet ist, und mit
    - einer zweiten Blendeneinheit (9), die zwischen der ersten Kondensorlinse (6, 6a, 6b, 6c) und der zweiten Kondensorlinse (7, 7a, 7b, 7c) angeordnet ist,

    wobei

    - die erste Kondensorlinse (6) einen ersten Polschuh (6a) und einen zweiten Polschuh (6b) aufweist, wobei ausgehend von dem Teilchenstrahlerzeuger (2) in Richtung der Objektivlinse (10) gesehen zunächst der erste Polschuh (6a) und dann der zweite Polschuh (6b) angeordnet sind
    und wobei
    - die zweite Blendeneinheit (9), vorzugsweise eine Dünnschichtblende, eine Druckstufenblende ist, die einen ersten Bereich, in welchem ein Vakuum mit einem ersten Druck herrscht, und einen zweiten Bereich, in welchem ein Vakuum mit einem zweiten Druck herrscht, voneinander trennt, **dadurch gekennzeichnet, dass**
    - sowohl der erste Polschuh (6a) als auch der zweite Polschuh (6b) unabhängig voneinander relativ zur zweiten Blendeneinheit (9) justierbar sind.

2. Teilchenstrahlgerät (1) nach Anspruch 1, wobei

    - die zweite Kondensorlinse (7) einen dritten Polschuh (7a) und einen vierten Polschuh (7b) aufweist, wobei ausgehend von dem Teilchenstrahlerzeuger (2) in Richtung der Objektivlinse (10) gesehen zunächst der dritte Polschuh (7a) und dann der vierte Polschuh (7b) angeordnet sind, und wobei
    - der dritte Polschuh (7a) und der vierte Polschuh (7b) gemeinsam oder unabhängig voneinander relativ zur zweiten Blendeneinheit (9) justierbar sind.

3. Teilchenstrahlgerät (1) nach Anspruch 1 oder 2, wobei zwischen der ersten Blendeneinheit (8) und der zweiten Kondensorlinse (7, 7a, 7b, 7c) mindestens eine Ablenkeinrichtung (25, 26, 27) angeordnet ist.

4. Teilchenstrahlgerät (1) nach einem der vorangehenden Ansprüche, wobei die erste Blendeneinheit (8) eine Blendenöffnung (98) mit einer veränderbaren Öffnungsgröße aufweist.

5. Teilchenstrahlgerät (1) nach Anspruch 4, wobei

    - die erste Blendeneinheit (8) ein erstes Blendenelement (85) und ein zweites Blendenelement (89) aufweist,
    - das erste Blendenelement (85) und das zweite Blendenelement (89) zur Bildung der Blendenöffnung (98) zusammenwirken, und wobei
    - das erste Blendenelement (85) und das zweite Blendenelement (89) relativ zueinander bewegbar sind.

**6.** Teilchenstrahlgerät (1) nach Anspruch 5, wobei

- die erste Blendeneinheit (8) ein erstes Blendenanschlagelement (182) und ein zweites Blendenanschlagelement (183) aufweist,
- das erste Blendenelement (85) derart beweglich ist, dass es an dem ersten Blendenanschlagelement (182) zur Bildung der Blendenöffnung (98) anliegt, und/oder wobei
- das zweite Blendenelement (89) derart beweglich ist, dass es an dem zweiten Blendenanschlagelement (183) zur Bildung der Blendenöffnung (98) anliegt.

**7.** Teilchenstrahlgerät (1) nach Anspruch 5, wobei

- die erste Blendeneinheit (8) ein erstes Anschlagelement (81) und ein zweites Anschlagelement (82) aufweist, und wobei
- das erste Blendenelement (85) derart beweglich ist, dass es an dem ersten Anschlagelement (81) zur Bildung der Blendenöffnung (98) mit einer ersten Öffnungsgröße oder an dem zweiten Anschlagelement (82) zur Bildung der Blendenöffnung (98) mit einer zweiten Öffnungsgröße anliegt.

**8.** Teilchenstrahlgerät (1) nach einem der Ansprüche 5 bis 7, wobei

- die erste Blendeneinheit (8) ein drittes Anschlagelement (83) und ein viertes Anschlagelement (84) aufweist, und wobei
- das zweite Blendenelement (89) derart beweglich ist, dass es an dem dritten Anschlagelement (83) oder dem vierten Anschlagelement (84) zur Bildung der Blendenöffnung (98) anliegt.

**9.** Teilchenstrahlgerät (1) nach einem der Ansprüche 5 bis 8, wobei das Teilchenstrahlgerät (1) mindestens eines der folgenden Merkmale aufweist:

- die erste Blendeneinheit (8) weist mindestens eine Antriebseinheit (95, 99) zur Bewegung des ersten Blendenelements (85) und/oder des zweiten Blendenetements (89) auf.
- die erste Blendeneinheit (8) weist mindestens eine Antriebseinheit (95, 99) zur Bewegung des ersten Blendenelements (85) und/oder des zweiten Blendenelements (89) auf, wobei die Antriebseinheit (95) ein Piezoelement aufweist,
- die erste Btendeneinheit (8) weist mindestens eine Antriebseinheit (95, 99) zur Bewegung des ersten Blendenelements (85) und/oder des zweiten Blendenelements (89) auf, wobei die Antriebseinheit ein elektromagnetisches Bewegungselement aufweist, oder
- die erste Blendeneinheit (8) weist mindestens eine Antriebseinheit (95, 99) zur Bewegung des ersten Blendenelements (85) und/oder des zweiten Blendenelements (89) auf, wobei die Antriebseinheit (99) ein Bimetall-Element aufweist.

**10.** Teilchenstrahlgerät (1) nach Anspruch 9, wobei die erste Blendeneinheit (8) mindestens eines der folgenden Merkmale aufweist:

- die Antriebseinheit (95) weist eine Versorgungseinheit (20) auf, welche die Antriebseinheit (95) mit Spannung versorgt, oder
- die Antriebseinheit (99) weist eine Versorgungseinheit (20) auf, welcher der Antriebseinheit (99) Wärme zuführt oder abführt.

**11.** Teilchenstrahlgerät (1) nach Anspruch 9 oder 10, wobei die Antriebseinheit (99) zur Steuerung mittels eines optischen Signals ausgelegt ist.

**12.** Teilchenstrahlgerät (1) nach einem der Ansprüche 5 bis 11, wobei das Teilchenstrahtgerät (1) mindestens eines der folgenden Merkmale aufweist:

- das erste Blendenelement (85) und das zweite Blendenelement (89) sind mittels eines federnden Verbindungselements (99) miteinander verbunden, oder
- das erste Blendenelement (85) und das zweite Blendenelement (89) sind mittels eines federnden Verbindungselements (99) miteinander verbunden, wobei das federnde Verbindungselement (99) als Bimetall ausgebildet ist.

**13.** Teilchenstrahlgetät (1) nach einem der Ansprüche 5 bis 11, wobei die erste Blendeneinheit (8) mindestens eines der folgenden Merkmale aufweist:

- das erste Blendenelement (85) ist zumindest teilweise federnd ausgebildet, oder
- das zweite Blendenelement (89) ist zumindest teilweise federnd ausgebildet.

**14.** Teilchenstrahlgerät (1) nach Anspruch 13, wobei die erste Blendeneinheit (8) mindestens eines der folgenden Merkmale aufweist:

- das erste Blendenelement (85) weist ein erstes Gelenkteil (86) und ein zweites Gelenkteil (87) auf, welche mittels einer ersten Gelenkstelle (88) miteinander verbunden sind, oder
- das zweite Blendenelement (89) weist ein drittes Gelenkteil (90) und ein viertes Gelenkteil (91) auf, welche mittels einer zweiten Gelenkstelle (92) miteinander verbunden sind.

**15.** Teilchenstrahlgerät (1) nach Anspruch 14, wobei die erste Blendeneinheit (8) mindestens eines der folgenden Merkmale aufweist:

- die erste Gelenkstelle (88) ist federnd ausgebildet, oder
- die zweite Gelenkstelle (92) ist federnd ausgebildet.

**16.** Teilchenstrahlgerät (1) nach einem der Ansprüche 6 bis 15, wobei die erste Blendeneinheit (8) mindestens eines der folgenden Merkmale aufweist:

- das erste Blendenanschlagelement (182) ist als Exzenter ausgebildet.
- das zweite Biendenanschlagelement (183) ist als Exzenter ausgebildet,
- das erste Anschlagelement (81) ist als Exzenter ausgebildet,
- das zweite Anschlagelement (82) ist als Exzenter ausgebildet,
- das dritte Anschlagelement (83) ist als Exzenter ausgebildet, oder
- das vierte Anschlagelement (84) ist als Exzenter ausgebildet.

**17.** Teilchenstrahlgerät (1) nach einem der vorangehenden Ansprüche, wobei die erste Blendeneinheit (8) auf einem Potential im Bereich von 1 kV bis 20 kV gegenüber einem Massepotential liegt.

**Claims**

**1.** Particle beam apparatus (1), comprising

- a particle beam generator (2) for generating particles forming a particle beam;
- an objective lens (10) for focusing the particle beam onto a sample (16);
- a first condenser lens (6, 6a, 6b, 6c) and a second condenser lens (7, 7a, 7b, 7c), the first condenser lens (6, 6a, 6b, 6c) being situated first, and then the second condenser lens (7, 7a, 7b, 7c) as viewed from particle beam generator (2) toward the objective lens (10);
- a first aperture unit (8) situated between the particle beam generator (2) and the first condenser lens (6, 6a, 6b, 6c); and
- a second aperture unit (9) situated between the first condenser lens (6, 6a, 6b, 6c) and the second condenser lens (7, 7a, 7b, 7c);

wherein

- the first condenser lens (6) has a first pole shoe (6a) and a second pole shoe (6b), wherein, as viewed from the particle beam generator (2) toward the objective lens (10), the first pole shoe (6a) is situated first, and then the second pole shoe (6b); and wherein
- the second aperture unit (9), preferably a thin-film aperture, is a pressure stage aperture separating a first area at a vacuum having a first pressure from a second area at a vacuum having a second pressure, from each other,

**characterized in that**

- both the first pole shoe (6a) and the second pole shoe (6b) are adjustable relative to the second aperture unit (9) independently of each other.

2. Particle beam apparatus (1) according to claim 1, wherein

- the second condenser lens (7) has a third pole shoe (7a) and a fourth pole shoe (7b), the third pole shoe (7a) being situated first, and then the fourth pole shoe (7b) as viewed from the particle beam generator (2) toward the objective lens (10); and
- the third pole shoe (7a) and the fourth pole shoe (7b) are adjustable relative to the second aperture unit (9) together or independently of each other.

3. Particle beam apparatus (1) according to claim 1 or 2, wherein at least one deflection unit (25, 26, 27) is situated between the first aperture unit (8) and the second condenser lens (7, 7a, 7b, 7c).

4. Particle beam apparatus (1) according to one of the preceding claims, wherein the first aperture unit (8) has an aperture opening (98) having a variable opening size.

5. Particle beam apparatus (1) according to claim 4, wherein

- the first aperture unit (8) has a first aperture element (85) and a second aperture element (89);
- the first aperture element (85) and the second aperture element (89) cooperate to form the aperture opening (98); and wherein
- the first aperture element (85) and the second aperture element (89) are movable relative to each other.

6. Particle beam apparatus (1) according to claim 5, wherein

- the first aperture unit (8) has a first aperture stop element (182) and a second aperture stop element (183);
- the first aperture element (85) is movable in such a way that it contacts the first aperture stop element (182) to form the aperture opening (98); and/or wherein
- the second aperture element (89) is movable in such a way that it contacts the second aperture stop element (183) to form the aperture opening (98).

7. Particle beam apparatus (1) according to claim 5, wherein

- the first aperture unit (8) has a first stop element (81) and a second stop element (82); and wherein
- the first aperture element (85) is movable in such a way that it contacts either the first stop element (81) to form the aperture opening (98) with a first opening size, or the second stop element (82) to form the aperture opening (98) with a second opening size.

8. Particle beam apparatus (1) according to one of claims 5 through 7, wherein

- the first aperture unit (8) has a third stop element (83) and a fourth stop element (84); and wherein
- the second aperture element (89) is movable in such a way that it contacts the third stop element (83) or the fourth stop element (84) to form the aperture opening (98).

9. Particle beam apparatus (1) according to one of claims 5 through 8, wherein the particle beam apparatus (1) has at least one of the following features:

- the first aperture unit (8) has at least one drive unit (95, 99) for moving the first aperture element (85) and/or the second aperture element (89),
- the first aperture unit (8) has at least one drive unit (95, 99) for moving the first aperture element (85) and/or the second aperture element (89), the drive unit (95) having a piezoelectric element,
- the first aperture unit (8) has at least one drive unit (95, 99) for moving the first aperture element (85) and/or the second aperture element (89), the drive unit having an electro-magnetic moving member, or
- the first aperture unit (8) has at least one drive unit (95, 99) for moving the first aperture element (85) and/or the second aperture element (89), the drive unit (99) having a bimetal element.

10. Particle beam apparatus (1) according to claim 9, wherein the first aperture unit (8) has at least one of the following features:

- the drive unit (95) has a supply unit (20) supplying voltage to the drive unit (95); or
- the drive unit (99) has a supply unit (20) supplying heat to the drive unit (99) or dissipating heat from it.

**11.** Particle beam apparatus (1) according to one of claims 9 and 10, wherein the drive unit (99) is designed to be controlled using an optical signal.

**12.** Particle beam apparatus (1) according to one of claims 5 through 11, wherein the particle beam apparatus (1) has at least one of the following features:

- the first aperture element (85) and the second aperture element (89) are connected to each other via an elastic connecting element (99), or
- the first aperture element (85) and the second aperture element (89) are connected to each other via an elastic connecting element (99), the elastic connecting element (99) being designed as a bimetal.

**13.** Particle beam apparatus (1) according to one of claims 5 through 11, wherein the first aperture unit (8) has at least one of the following features:

- the first aperture element (85) is at least partially elastically designed; or
- the second aperture element (89) is at least partially elastically designed.

**14.** Particle beam apparatus (1) according to claim 13, wherein the first aperture unit (8) has at least one of the following features:

- the first aperture element (85) has a first jointed part (86) and a second jointed part (87) connected to each other by a first joint (88); or
- the second aperture element (89) has a third jointed part (90) and a fourth jointed part (91) connected to each other by a second joint (92).

**15.** Particle beam apparatus (1) according to claim 14, wherein the first aperture unit (8) has at least one of the following features:

- the first joint (88) is elastically designed; or
- the second joint (92) is elastically designed.

**16.** Particle beam apparatus (1) according to one of claims 6 through 15, wherein the first aperture unit (8) has at least one of the following features:

- the first aperture stop element (182) is eccentrically designed;
- the second aperture stop element (183) is eccentrically designed;
- the first stop element (81) is eccentrically designed;
- the second stop element (82) is eccentrically designed;
- the third stop element (83) is eccentrically designed; or
- the fourth stop element (84) is eccentrically designed.

**17.** Particle beam apparatus (1) according to one of the preceding claims, wherein the first aperture unit (8) is at a potential in the range from 1 kV to 20 kV with respect to a ground potential.

**Revendications**

**1.** Appareil à faisceau de particules (1), comprenant

- un générateur de faisceau de particules (2) pour générer des particules, lesquelles constituent un faisceau de particules,
- une lentille d'objectif (10) pour focaliser le faisceau de particules sur un échantillon (16),
- une première lentille de condensateur (6, 6a, 6b, 6c) et une seconde lentille de condensateur (7, 7a, 7b, 7c) qui, en regardant depuis le générateur de faisceau de particules (2) vers la lentille d'objectif (10), sont agencées l'une derrière l'autre en commençant par la première lentille de condensateur (6, 6a, 6b, 6c) et ensuite la seconde lentille de condensateur (7, 7a, 7b, 7c),
- une première unité de diaphragme (8), qui est agencée entre le générateur de faisceau de particules (2) et la première lentille de condensateur (6, 6a, 6b, 6c), et avec
- une seconde unité de diaphragme (9), qui est agencée entre la première lentille de condensateur (6, 6a, 6b, 6c) et la seconde lentille de condensateur (7, 7a, 7b, 7c),
dans lequel
- la première lentille de condensateur (6) présente une première pièce polaire (6a) et une deuxième pièce polaire (6b) qui, en regardant depuis le générateur de faisceau de particules (2) vers la lentille d'objectif (10), sont agencées l'une derrière l'autre en commençant par la première pièce polaire (6a), et ensuite la deuxième pièce polaire (6b)
et dans lequel
- la seconde unité de diaphragme (9), de préférence un diaphragme à film mince, est un diaphragme à palier de pression, qui sépare une première zone, dans laquelle règne un vide à une première pression, et une seconde zone, dans laquelle règne un vide à une seconde pression,

**caractérisé en ce que**
non seulement la première pièce polaire (6a) mais également la deuxième pièce polaire (6b) sont réglables indépendamment l'une de l'autre par rapport à la seconde unité de diaphragme (9).

2. Appareil à faisceau de particules (1) selon la revendication 1, dans lequel

- la seconde lentille de condensateur (7) présente une troisième pièce polaire (7a) et une quatrième pièce polaire (7b) qui, en regardant depuis le générateur de faisceau de particules (2) vers la lentille d'objectif (10), sont agencées l'une derrière l'autre en commençant par la troisième pièce polaire (7a), et ensuite la quatrième pièce polaire (7b), et dans lequel
- la troisième pièce polaire (7a) et la quatrième pièce polaire (7b) sont réglables simultanément indépendamment l'une de l'autre par rapport à la seconde unité de diaphragme (9).

3. Appareil à faisceau de particules (1) selon la revendication 1 ou 2, dans lequel au moins un déflecteur (25, 26, 27) est agencé entre la première unité de diaphragme (8) et la seconde lentille de condensateur (7, 7a, 7b, 7c).

4. Appareil à faisceau de particules (1) selon l'une quelconque des revendications précédentes, dans lequel la première unité de diaphragme (8) présente une ouverture de diaphragme (98) ayant une taille d'ouverture variable.

5. Appareil à faisceau de particules (1) selon la revendication 4, dans lequel

- la première unité de diaphragme (8) présente un premier élément de diaphragme (85) et un second élément de diaphragme (89),
- le premier élément de diaphragme (85) et le second élément de diaphragme (89) collaborent pour mettre en oeuvre l'ouverture de diaphragme (98), et dans lequel
- le premier élément de diaphragme (85) et le second élément de diaphragme (89) peuvent être déplacés l'un par rapport à l'autre.

6. Appareil à faisceau de particules (1) selon la revendication 5, dans lequel

- la première unité de diaphragme (8) présente un premier élément de butée de diaphragme (182) et un second élément de butée de diaphragme (183),
- le premier élément de diaphragme (85) est mobile de manière à être placé contre le premier élément de butée de diaphragme (182) pour mettre en oeuvre l'ouverture de diaphragme (98), et/ou dans lequel
- le second élément de diaphragme (89) est mobile de manière à être placé contre le second élément de butée de diaphragme (183) pour mettre en oeuvre l'ouverture de diaphragme (98).

7. Appareil à faisceau de particules (1) selon la revendication 5, dans lequel

- la première unité de diaphragme (8) présente un premier élément de butée (81) et un deuxième élément de butée (82), et dans lequel

- le premier élément de diaphragme (85) est mobile de manière à être placé contre le premier élément de butée (81) pour mettre en oeuvre l'ouverture de diaphragme (98) avec une première taille d'ouverture ou contre le deuxième élément de butée (82) pour mettre en oeuvre l'ouverture de diaphragme (98) avec une seconde taille d'ouverture.

8. Appareil à faisceau de particules (1) selon l'une quelconque des revendications 5 à 7, dans lequel

- la première unité de diaphragme (8) présente un troisième élément de butée (83) et un quatrième élément de butée (84), et dans lequel
- le second élément de diaphragme (89) est mobile de manière à être placé contre le troisième élément de butée (83) ou contre le quatrième élément de butée (84) pour mettre en oeuvre l'ouverture de diaphragme (98).

9. Appareil à faisceau de particules (1) selon l'une quelconque des revendications 5 à 8, dans lequel l'appareil à faisceau de particules (1) présente au moins l'une des caractéristiques suivantes :

- la première unité de diaphragme (8) présente au moins une unité d'entraînement (95, 99) pour déplacer le premier élément de diaphragme (85) et/ou le second élément de diaphragme (89),
- la première unité de diaphragme (8) présente au moins une unité d'entraînement (95, 99) pour déplacer le premier élément de diaphragme (85) et/ou le second élément de diaphragme (89), l'unité d'entraînement (95) présentant un élément piézo-électrique,
- la première unité de diaphragme (8) présente au moins une unité d'entraînement (95, 99) pour déplacer le premier élément de diaphragme (85) et/ou le second élément de diaphragme (89), l'unité d'entraînement présentant un élément de déplacement électromagnétique, ou
- la première unité de diaphragme (8) présente au moins une unité d'entraînement (95, 99) pour déplacer le premier élément de diaphragme (85) et/ou le second élément de diaphragme (89), l'unité d'entraînement (99) présentant un élément bimétallique.

10. Appareil à faisceau de particules (1) selon la revendication 9, dans lequel la première unité de diaphragme (8) présente au moins l'une des caractéristiques suivantes :

- l'unité d'entraînement (95) présente une unité d'alimentation (20), qui fournit une tension à l'unité d'entraînement (95), ou
- l'unité d'entraînement (99) présente une unité d'alimentation (20), qui évacue la chaleur de l'unité d'entraînement (99), ou qui conduit de la chaleur vers celle-ci.

11. Appareil à faisceau de particules (1) selon la revendication 9 ou 10, dans lequel l'unité d'entraînement (99) est positionnée pour commander à l'aide d'un signal optique.

12. Appareil à faisceau de particules (1) selon l'une quelconque des revendications 5 à 11, dans lequel l'appareil à faisceau de particules (1) présente au moins l'une des caractéristiques suivantes :

- le premier élément de diaphragme (85) et le second élément de diaphragme (89) sont reliés l'un à l'autre au moyen d'un élément de liaison élastique (99), et
- le premier élément de diaphragme (85) et le second élément de diaphragme (89) sont reliés l'un à l'autre au moyen d'un élément de liaison élastique (99), l'élément de liaison élastique (99) étant réalisé sous une forme bimétallique.

13. Appareil à faisceau de particules (1) selon l'une quelconque des revendications 5 à 11, dans lequel la première unité de diaphragme (8) présente au moins une des caractéristiques suivantes :

- le premier élément de diaphragme (85) est réalisé au moins partiellement élastique, ou
- le second élément de diaphragme (89) est réalisé au moins partiellement élastique.

14. Appareil à faisceau de particules (1) selon la revendication 13, dans lequel la première unité de diaphragme (8) présente au moins une des caractéristiques suivantes :

- le premier élément de diaphragme (85) présente une première pièce d'articulation (86) et une deuxième pièce d'articulation (87), qui sont reliées l'une à l'autre à l'aide d'un premier point d'articulation (88), ou

- le deuxième élément de diaphragme (89) présente une troisième pièce d'articulation (90) et une quatrième pièce d'articulation (91), qui sont reliées l'une à l'autre à l'aide d'un second point d'articulation (92).

15. Appareil à faisceau de particules (1) selon la revendication 14, dans lequel la première unité de diaphragme (8) présente au moins une des caractéristiques suivantes :

   - le premier point d'articulation (88) est réalisé élastique, ou
   - le second point d'articulation (92) est réalisé élastique.

16. Appareil à faisceau de particules (1) selon l'une quelconque des revendications 6 à 15, dans lequel la première unité de diaphragme (8) présente au moins une des caractéristiques suivantes :

   - le premier élément de butée de diaphragme (182) est réalisé sous la forme d'un excentrique,
   - le second élément de butée de diaphragme (183) est réalisé sous la forme d'un excentrique,
   - le premier élément de butée (81) est réalisé sous la forme d'un excentrique,
   - le deuxième élément de butée (82) est réalisé sous la forme d'un excentrique,
   - le troisième élément de butée (83) est réalisé sous la forme d'un excentrique, ou
   - le quatrième élément de butée (84) est réalisé sous la forme d'un excentrique.

17. Appareil à faisceau de particules (1) selon l'une quelconque des revendications précédentes, dans lequel la première unité de diaphragme (8) est à un potentiel dans la plage de 1 kV à 20 kV par rapport à un potentiel de masse.

Fig. 1

Fig.2

Fig. 3

Fig. 4

Fig. 5

Fig.6

Fig. 7

Fig. 8

Fig. 9

Fig. 10

**EP 2 278 607 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7550724 B2
- US 20070138403 A1
- JP 61076673 U
- US 3526766 A
- JP 59221953 A
- JP 11086767 A
- US 20070257207 A
- US 3588586 A